(19) **Europäisches Patentamt / European Patent Office / Office européen des brevets**

(11) **EP 4 756 050 A1**

(12) **EUROPEAN PATENT APPLICATION**
published in accordance with Art. 153(4) EPC

(43) Date of publication:
**10.06.2026  Bulletin 2026/24**

(21) Application number: **24849036.9**

(22) Date of filing: **25.07.2024**

(51) International Patent Classification (IPC):
*C22C 21/00* (2006.01)      *C22F 1/00* (2006.01)
*C22F 1/04* (2006.01)      *H01B 1/02* (2006.01)
*H01B 5/02* (2006.01)      *H01L 21/60* (2006.01)

(52) Cooperative Patent Classification (CPC):
**C22C 21/00; C22F 1/00; C22F 1/04; H01B 1/02;
H01B 5/02; H10W 72/071**

(86) International application number:
**PCT/JP2024/026568**

(87) International publication number:
**WO 2025/028381 (06.02.2025 Gazette 2025/06)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **31.07.2023  JP 2023124294**

(71) Applicant: **Tanaka Electronics Co., Ltd.
Saga 842-0031 (JP)**

(72) Inventors:
• **SUGIYAMA, Toshihiko
  Kanzaki-gun, Saga 842-0031 (JP)**

• **MIKAMI, Michitaka
  Kanzaki-gun, Saga 842-0031 (JP)**
• **CHEN, Wei
  Kanzaki-gun, Saga 842-0031 (JP)**
• **CHIBA, Jun
  Kanzaki-gun, Saga 842-0031 (JP)**
• **MITOMA, Shuichi
  Kanzaki-gun, Saga 842-0031 (JP)**
• **IYONAGA, Yukihiro
  Kanzaki-gun, Saga 842-0031 (JP)**
• **ICHIKAWA, Tsukasa
  Kanzaki-gun, Saga 842-0031 (JP)**

(74) Representative: **Plougmann Vingtoft a/s
Strandvejen 70
2900 Hellerup (DK)**

(54) **ALUMINUM WIRING MATERIAL AND METHOD FOR MANUFACTURING SAME**

(57)    There are provided an aluminum wiring material (51) exhibiting excellent long-term bonding reliability under a temperature cycle, excellent conformability to a wedge tool, and excellent vibration resistance, and a manufacturing method thereof. An aluminum wiring material (51) made of aluminum having a purity of less than 99.9 mass %, wherein in a cross section perpendicular to a longitudinal direction thereof, an orientation ratio of a crystal orientation <112> having an angular difference of 10° or less is 45% or less, a ratio of the number of precipitated particles having an aspect ratio of 4 or more to the total number of precipitated particles is 0.50 or more and 16% or less, a load stress ratio is 0.4 or more and 0.9 or less, a proof stress ratio is greater than 1.0 and 2.3 or less, and the aluminum wiring material (51) contains, relative to the total amount thereof, at least one element of iron and silicon in a total amount of 0.01 mass % or more and 1 mass % or less, and at least one element of gallium and vanadium in a total amount of 50 mass ppm or more and 800 mass ppm or less.

EP 4 756 050 A1

**Description**

Technical Field

The present invention relates to an aluminum wiring material, and particularly to an aluminum wiring material that is used for conduction and exhibits excellent bonding reliability at high temperatures, excellent conformability during bonding, and high strength against vibration, as well as a method for manufacturing the same.

Background Art

Conventionally, aluminum wiring materials have been used as a wiring material for connecting an electrode of a lithium ion battery to a bus bar and as a bonding wiring material for a power semiconductor.

Lithium ion batteries are used as drive batteries (power sources) for hybrid vehicles (HV), plug-in hybrid vehicles (PHV, PHEV), and electric vehicles. Hybrid vehicles and plug-in hybrid vehicles employ a gasoline engine and an electric motor as driving power sources. Electric vehicles employ only an electric motor as the driving power source. Hybrid vehicles and electric vehicles travel by driving an electric motor using electric power charged in a lithium ion battery. As drive batteries, lead batteries and nickel-hydrogen batteries can also be used in addition to lithium ion batteries. However, lithium ion batteries are increasingly being employed in electric vehicles that prioritize fuel economy because they have a longer lifespan and are lighter, smaller, and higher in output.

As lithium batteries for drive batteries of electric vehicles, cylindrical batteries are widely used because they are compact, have a stable shape, and are easy to replace. A cylindrical battery has a structure in which an electrolyte solution and the like are sealed in a cylindrical metal case. A battery pack using cylindrical batteries includes, for example, an outer case connected to lead members (bus bars), a plurality of cylindrical batteries accommodated in the outer case, and a wiring material that connects electrodes of the cylindrical batteries to the lead members. An aluminum wiring material made of an aluminum alloy is advantageous in terms of electrical conductivity and cost, and is thus widely used as the wiring material for cylindrical batteries.

A power semiconductor is also referred to as a power chip, power semiconductor, power device, power element, power semiconductor element, or the like. A power semiconductor includes power chips, bonding wiring materials that connect the power chips to each other, and bonding wiring materials that connect the power chips to external electrodes. The power semiconductor serves to drive a motor, charge a battery, and supply power for operating a microcontroller and a large-scale integrated circuit (LSI). The major power chips used in the field of transportation using automobiles and the like are insulated gate bipolar transistors (IGBTs) and metal-oxide-semiconductor field-effect transistors (MOSFETs), which are suitable for high power. As bonding wiring materials for power semiconductors, relatively thick aluminum wiring materials having a wire diameter (diameter) of 40 $\mu$m or more and 700 $\mu$m or less are often used in order to carry a large current. A circuit for a power supply in which multiple power semiconductors are combined and integrated into a single package is referred to as a "power module."

Regarding the bonding of a bus bar to a wiring material, or the bonding of a bonding wiring material for a power semiconductor, a common method is to hold the tip of the wiring material with a gripping device called a wedge tool (also simply referred to as a "tool") and press the wiring material against a lead member or an electrode together with the wedge tool while applying ultrasonic waves to the wiring material. The material is then crushed and deformed, thereby bonding the lead member or the electrode to the wiring material.

Electric vehicles, on the other hand, are used in diverse external environments, such as in cold regions, tropical regions, high-humidity regions, and regions with high dryland salinity. For example, when an electric vehicle travels in a cold or tropical region, it is subjected to low-temperature or high-temperature environments, and to changes in these temperatures, for an extended period of time. To ensure the safety of the electric vehicle, the power modules and drive batteries mounted on the electric vehicle, as well as the aluminum wiring materials bonded thereto, are required to be compatible with all the environments conceivable for the usage of such electric vehicles.

In addition to the temperature changes in the external environment, the power modules and the drive batteries in electric vehicles are subjected to temperature variations caused by heating and cooling due to the electrical current. An electric vehicle repeatedly undergoes a cycle of stopping and starting the supply of current when the vehicle stops and starts being driven, respectively. Consequently, the power chips generate heat due to the energization, reaching a high temperature, and are rapidly cooled when the energization is stopped. The aluminum wiring materials bonded to the power chips and the drive batteries are also exposed to this temperature cycle of heating and cooling. When the electric vehicle is operated for an extended period of time, the frequent repetition of acceleration and braking leads to the frequent repetition of this temperature cycle of heating and cooling. In this process, for example, heat stress is generated because of the difference in the coefficient of heat expansion between the power chip and the aluminum wiring material, such heat stress possibly leading to metal fatigue in the bonding portion between the power chip and the aluminum wiring material or in the aluminum wiring material itself. This metal fatigue increases the possibility of peeling or rupture of the bonding portion or the possibility of cracks occurring in the aluminum wiring material. Accordingly, there has been a demand for an aluminum wiring material that exhibits long-term bonding reliability, even when such a temperature cycle of heating and cooling is repeated.

Furthermore, a power transistor, which is a type of power semiconductor, is used in an inverter. The inverter is mounted in energy-saving household appliances (hereinafter also referred to as "energy-saving appliances") such as air conditioners, refrigerators, and washing machines. When the power transistor switches the current ON and OFF (switching), the inverter controls the rotational speed of a motor that drives the household appliance. By using an inverter, wasteful operation of the motor is reduced, thereby achieving energy savings and, for example, in the case of an air conditioner, stably maintaining the temperature of the room. Similar to the process described above, the switching operation of the power transistor also involves the repetition of the temperature cycle of heating and cooling, caused by the energization and its cessation, of the wiring material.

Conventionally, in order to prevent breakage and failure of a power module in a high temperature state, various techniques have been investigated, such as a technique for avoiding chip damage, a technique for improving the strength of a bonding wire, and a technique for improving the long-term reliability of a bonding portion (see, for example, Patent Literatures 1 to 5).

Furthermore, accompanying the miniaturization of the household appliances, attempts have been made to make power semiconductors smaller, thinner, and more dense. Such changes reduce the bonding space for the aluminum wiring material and, as a result, increase the bending of the aluminum wiring material. Accordingly, conformability to such bending is demanded of the aluminum wiring material. In the case where an aluminum wiring material with low conformability to bending is used, when the aluminum wiring material is laterally bent at a preset angle (e.g., 45°) by the wedge tool, the wiring material may be unable to follow the lateral bending movement of the wedge tool, and a portion thereof may become detached from the alligator chip of the wedge tool. If a second bonding is performed while a portion of the wire is detached, the bonding position may deviate from the intended position and come into contact with another electrode, thereby potentially causing a short-circuit failure. Furthermore, if the wire detaches from the tool, the tip of the wedge tool may come into contact with the element and damage the semiconductor element. In particular, conventional wiring materials aimed at long-term reliability generally tend to have high tensile strength, proof stress, and hardness (hereinafter collectively referred to as "strength"). Conversely, wiring materials with higher strength tend to have lower conformability. Accordingly, attempts have also been made to achieve both long-term reliability and wire conformability (see, for example, Patent Literature 5).

The invention described in Patent Literature 1 is "characterized in that a thin aluminum alloy wire for ultrasonic bonding of a semiconductor device, the wire including 0.2 to 2.0 mass % of iron (Fe) and the balance of aluminum (Al) having a purity of 99.99 mass % or more, wherein 0.01 to 0.05% of iron (Fe) is dissolved in an aluminum (Al) matrix of the thin aluminum alloy wire, a drawn matrix structure in a cross section of the thin aluminum alloy wire is a homogeneous fine recrystallized structure on the order of several $\mu$m, and intermetallic compound particles of iron (Fe) and aluminum (Al) are uniformly crystallized on the interface and the inner surface of the structure." Patent Literature 1 describes that, by adding a step of solutionizing and quenching treatment before the tempering heat treatment, the amount of iron (Fe) dissolved in the aluminum (Al) matrix is increased up to 0.052%, which is the solid solubility limit at 650°C. This added step, combined with subsequent conventional continuous cold wire drawing and subsequent tempering heat treatment, makes it possible to make the crystal grain diameter of an Al-Fe alloy wire finer; and that, by increasing the purity of Al, dynamic recrystallization is caused during bonding to avoid chip damage (see paragraph 0013 of the description).

The invention described in Patent Literature 2 is "a thin aluminum alloy wire for ultrasonic bonding to an aluminum pad of a semiconductor element, the wire including iron (Fe), silicon (Si), and the balance being a high-purity aluminum (Al) alloy, wherein the thin aluminum alloy wire is an alloy containing 0.01 to 0.2 mass % of iron (Fe), 1 to 20 mass ppm of silicon (Si), and the balance being aluminum (Al) having a purity of 99.997 mass % or more, and has a fine structure having a solid solution amount of Fe of 0.01 to 0.06%, a precipitation amount of Fe that is 7 times or less the Fe solid solution amount, and an average crystal grain diameter of 6 to 12 $\mu$m." Patent Literature 2 describes that the recrystallization temperature is stabilized by maintaining the ratio of the Fe precipitation amount and the Fe solid solution amount within a predetermined range, and the addition of a trace amount of Si further improves the strength, thereby stabilizing the results of a heat shock test (see paragraph 0012 of the description).

The invention described in Patent Literature 3 is "characterized in that the wiring material is formed of Al or an Al alloy, has an average crystal grain diameter of 0.01 to 50 $\mu$m in a cross section perpendicular to the wiring material axis, and, when crystal orientations are measured in the cross section perpendicular to the wiring material axis, has an orientation ratio of <111> crystal orientations that have an angular difference of 15° or less with respect to the longitudinal direction of the wiring material, among the crystal orientations in the longitudinal direction of the wiring material, in a range of 30 to 90%." Patent Literature 3 describes that even when a semiconductor device is continuously operated for an extended period of time in a high temperature environment, the reliability of the bonding portions in the semiconductor device can be ensured after long-term operation at high temperatures (see paragraph 0012 of the description).

The invention described in Patent Literature 4 is "characterized in that 0.02 to 1 mass % of Fe is contained, a total of 0.05 to 0.5 mass % of at least one or more types of Mn and Cr is further contained, the balance being Al and unavoidable impurities, and the total solid solution amount of Fe, Mn, and Cr is 0.01 to 1 mass %." Patent Literature 4 describes that, in addition to containing Fe, a predetermined amount of one or both of Mn and Cr is contained, and that, by setting the total solid solution amount of Fe, Mn, and Cr to 0.01 to 1% in a solution heat treatment and a subsequent quenching treatment, the recrystallization temperature of the wire is increased. As a result, even when a semiconductor device is continuously used for an extended period of time in a high temperature environment, the progress of recrystallization of the bonding wire can be sufficiently suppressed, and a reduction in wire strength can be prevented (see paragraph 0014 of the description). Further, Patent Literature 4 describes that, in a cross section (C section) perpendicular to the longitudinal direction of the bonding wire, the area ratio (<111> orientation area ratio) of crystal having a <111> crystal orientation with an angular difference of 15° or less with respect to the longitudinal direction of the bonding wire is preferably 30 to 90%, and that recrystallization caused by tempering heat treatment during wire drawing appropriately proceeds to soften the wire, thereby preventing chip cracking during bonding, deterioration in bondability at the bonding portion, and the like (see paragraph 0026 of the description).

The invention described in Patent Literature 5 is "characterized by an aluminum wire comprising an aluminum alloy having an aluminum purity of 99 mass % or more, wherein the aluminum wire contains a total of 0.01 mass % or more and 1 mass % or less of iron and silicon relative to the total amount of the aluminum alloy, and wherein, in a lateral cross section perpendicular to the wire axis of the aluminum wire, the orientation index of (111) is 1 or more, the orientation index of (200) is 1 or less, and the area ratio of precipitated particles is 0.02% or more and 2% or less." Patent Literature 5 describes that when predetermined amounts of iron and silicon are contained, the orientation index of (111) in the lateral cross section perpendicular to the wire axis is set to 1 or more and the orientation index of (200) is set to 1 or less, a long service life is achieved in a power cycle test (see paragraph 0044 of the specification thereof), and that when the area ratio of precipitated particles is set to 0.02% or more and 2% or less, the wire can be prevented from detaching from the wedge tool during the bonding of the bonding wire for a power semiconductor (see paragraph 0050 of the specification thereof).

Citation List

Patent Literature

PTL 1: Japanese Patent Application Publication No. 2013-258324
PTL 2: Japanese Patent Application Publication No. 2014-129578
PTL 3: International Publication No. 2020/184655
PTL 4: Japanese Patent Application Publication No. 2020-059886
PTL 5: International Publication No. 2022/163606

Summary of Invention

Technical Problem

As an example of a compact power semiconductor as described above, power semiconductors having a thickness of 65 $\mu$m and IGBTs having a thickness of 50 $\mu$m have been conventionally known. Further, not only miniaturization of power semiconductors but also miniaturization and thinning of semiconductor packages have been attempted. This is because the miniaturization and thinning of semiconductor packages lead to, for example, lightweight of electric vehicles, and as a result, an improvement in fuel efficiency is expected. Specifically, IGBT packages having a height (thickness) of about 20 to 40 mm were widely adopted in the 2000s, IGBT packages having a height of 14 mm were also used in 2014, and next-generation general-purpose packages having a height of 5 mm have been present in recent years. The semiconductor package includes a power semiconductor, a bonding wiring material, and if necessary, a resin for sealing the power semiconductor and the bonding wiring material.

In addition, development of electric vehicles and household appliances having higher capabilities and multifunctionality has been progressing. In order to achieve high performance and multifunctionality, a high driving force is required, and hence a large current is supplied to the power semiconductor. Therefore, in a power semiconductor aiming at achieving high performance and multifunctionality, a thicker aluminum wiring material that allows a large current to easily flow is often used. For example, an aluminum wiring material having a wire diameter of about 300 $\mu$m has been conventionally used, and some products use an aluminum wiring material having a wire diameter of about 500 $\mu$m.

A reduction in wiring resistance in the semiconductor package is also important in terms of energy saving of the electric vehicles and the household appliances. In order to reduce electric power to be consumed by wiring resistance, that is, the electric resistance of the aluminum wiring material, it is effective that bonding is achieved so that the height of a loop is low (low loop) and the length of the loop is short (short loop), to reduce the length of the aluminum wiring material. Here, the loop height refers to a height between the lowest portion of the bonding portion of the wiring material and the highest portion of the loop, and the loop length refers to a direct distance between both ends of first bonding and second bonding.

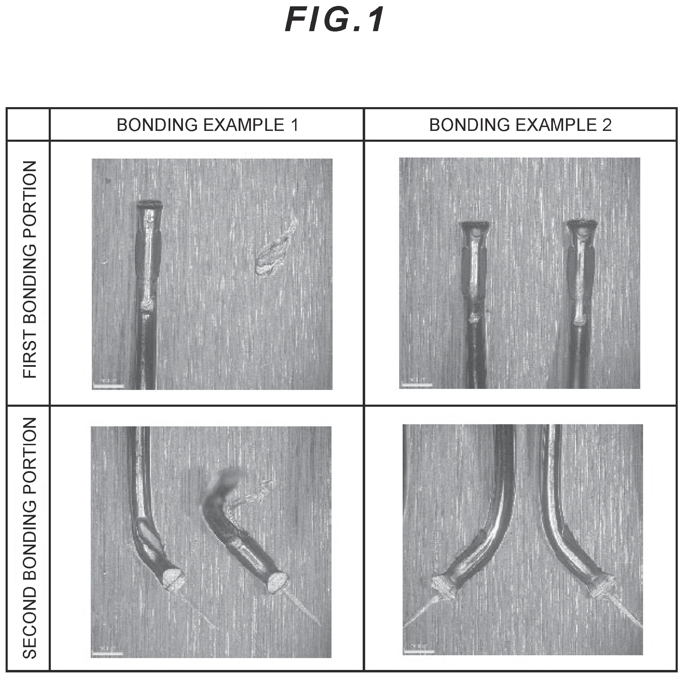

Further, the conventional wiring material aiming at achieving long-term reliability tends to have higher strength as described above, and has, on the other hand, lower vibration resistance as the strength is higher. When the elongation ratio of the aluminum wiring material is increased by reducing the alloy component of the aluminum wiring material, the vibration resistance is improved, but the rupture strength is reduced, and the long-term bonding reliability is reduced. In recent years, higher long-term bonding reliability has been particularly required, and so the strength of the aluminum wiring material has been high. Therefore, it has been more difficult to achieve both long-term bonding reliability and vibration resistance. Similarly, it has been increasingly difficult to achieve both long-term bonding reliability and the conformability to a wedge tool. Here, Fig. 1 shows enlarged photographs of a first bonding portion and a second bonding portion in a bonding example in which a wiring material having insufficient conformability to a wedge tool is detached from the wedge tool (Bonding Example 1) and a bonding example in which the wiring material is not detached from the wedge tool (Bonding Example 2). The upper and lower photographs on the left side of Fig. 1 show the first bonding portion and the second bonding portion in which the wiring material is detached from the wedge tool. The upper and lower photographs on the right side of Fig. 1 show the first bonding portion and the second bonding portion that are normal and in which the wiring material is not detached from the wedge tool. For example, a bonding material in Bonding Example 1 has insufficient conformability and attachment failed because the wiring material detached from the wedge tool in the first bonding portion.

Electric vehicles are used in various environments, such as a region where road surface maintenance is not sufficient and the evenness of the road is low. When an electric vehicle travels, for example, in a region with low evenness, not only the vehicle body but also various members and devices mounted in the electric vehicle are constantly vibrated due to the roughness of the road surface. Therefore, a power semiconductor using an aluminum wiring material having insufficient vibration resistance has a risk of failure when such an electric vehicle travels. Furthermore, a temperature cycle is also applied to the power semiconductor when the electric vehicle travels. Accordingly, in order to ensure safety, an aluminum wiring material that is installed in an electric vehicle is required to exhibit high vibration resistance and long-term bonding reliability.

The present inventors have intensively advanced the development of an aluminum wiring material that is compact and thin and can achieve high driving force and energy saving to apply the aluminum wiring material to a product having higher performance and a higher functionality. As a result, the inventors have found that when an aluminum wiring material is bonded to a power chip in a small bonding space, stress caused by bending at a neck portion of the aluminum wiring material (the rising portion of the wiring material bonded to a semiconductor) increases as the diameter of the wiring material becomes larger.

In addition, the inventors have also found that in a power semiconductor package exposed to the temperature cycle of current-induced heating and cooling, experiencing the temperature cycle causes rupture of a bonding portion, particularly, a crack on the lower side of the neck portion (a side to be bonded to the chip), and separately a crack on the upper side of the neck portion caused by the stress from bending at the neck portion, and the wiring material may be ruptured depending on how the cracks are caused.

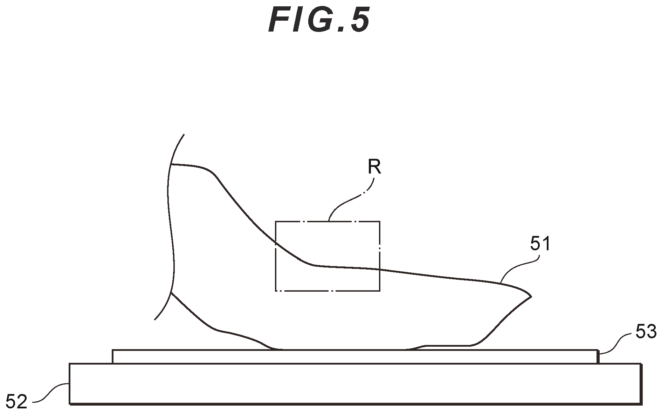

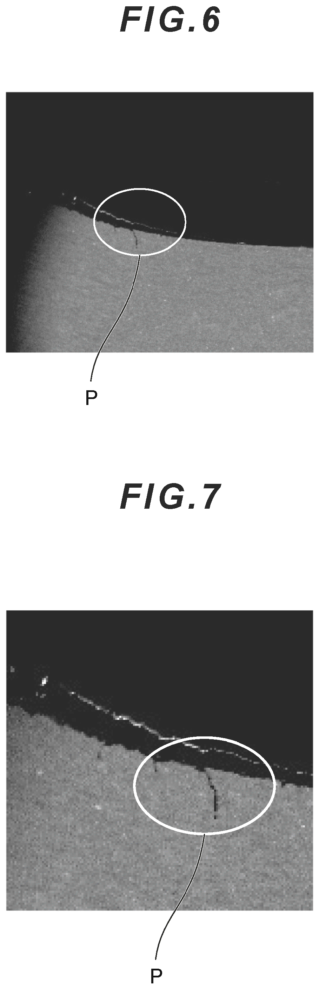

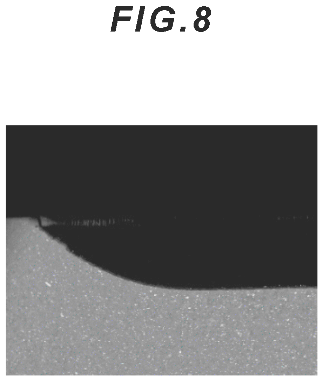

The inventors also have found that in a recent compact and thin semiconductor package, stress caused by bending is increased, and thereby the neck portion, particularly the upper side of the neck portion (a side opposite to a bonding of the chip) is likely to be cracked, which may rupture the wiring material. Here, a crack on the upper side of the wiring material will be described with reference to Fig. 5 to Fig. 8. Fig. 5 is a view illustrating an observation region R of an aluminum wiring material during observation of the crack on the upper side. In Fig. 5, an aluminum wiring material 51 is subjected to second bonding (wedge bonding) on an aluminum pad 53 on the surface of a test element group (TEG) chip 52. Fig. 6 is a photograph of a portion corresponding to the observation region R of a photograph obtained by photographing a neck rising portion of the aluminum wiring material through backscattered electron imaging with a scanning electron microscope (SEM-BEI). Here, the neck rising portion was obtained by wedge bonding the aluminum wiring material to the TEG chip with a low loop height, sealing the aluminum wiring material with a resin, repeating heating and cooling, and applying vibration thereto a preset number of times. Fig. 7 is a partially enlarged photograph of Fig. 6. Fig. 6 and Fig. 7 show that a small crack exists at a region P indicated on the upper side of the aluminum wiring material of the neck rising portion. In contrast, Fig. 8 is a photograph of an aluminum wiring material in which a crack was not observed at the observation region R. In recent compact and thin semiconductor packages, a fine crack, as shown in Fig. 6 and Fig. 7, can occur on the upper side of the neck portion. Further, a crack can also occur on the lower side of the neck portion. When a crack develops on both the lower side and the upper side of the neck portion, a synergistic effect of the cracks on both sides accelerates the development of cracks, and a risk of rupture at the neck portion could increase.

The present invention has been made to solve the above-mentioned problems, and an object of the present invention is to provide an aluminum wiring material exhibiting excellent long-term bonding reliability under a temperature cycle, excellent conformability to a wedge tool, and excellent vibration resistance. Another object of the present invention is to provide a method for manufacturing an aluminum wiring material exhibiting excellent long-term bonding reliability, excellent conformability to bending, and excellent vibration resistance.

Solution to Problem

Embodiments of the present invention are as described below.

[1] An aluminum wiring material made of aluminum having a purity of less than 99.9 mass %, wherein

in a cross section perpendicular to a longitudinal direction of the aluminum wiring material,
an orientation ratio of a crystal orientation <112> having an angular difference of 10° or less with respect to the longitudinal direction is 45% or less,
a ratio of the number of precipitated particles having an aspect ratio of 4 or more to the total number of precipitated particles in the cross section is 0.5% or more and 16% or less,
a load stress ratio defined by the following expression (1) is 0.4 or more and 0.9 or less:

load stress ratio = fatigue limit/tensile strength (1),
a proof stress ratio defined by the following expression (2) is greater than 1.0 and 2.3 or less:

proof stress ratio = maximum stress/0.2% proof stress (2), and
the aluminum wiring material contains, relative to the total amount thereof, at least one element of iron (Fe) and silicon (Si) in a total amount of 0.01 mass % or more and 1 mass % or less, and at least one element of gallium (Ga) and vanadium (V) in a total amount of 50 mass ppm or more and 800 mass ppm or less.

[2] The aluminum wiring material according to [1], wherein the aluminum wiring material has an average crystal grain diameter of 40 μm or less in the cross section perpendicular to the longitudinal direction of the aluminum wiring material.
[3] The aluminum wiring material according to [1] or [2], wherein the aluminum wiring material further contains one or more elements selected from magnesium (Mg), copper (Cu), nickel (Ni), zinc (Zn), chromium (Cr), manganese (Mn), titanium (Ti), zirconium (Zr), tungsten (W), and scandium (Sc).
[4] The aluminum wiring material according to any one of [1] to [3], wherein the aluminum wiring material has a wire diameter of 15 μm or more and 700 μm or less.
[5] The aluminum wiring material according to any one of [1] to [4], wherein the cross section perpendicular to the longitudinal direction of the aluminum wiring material has a circular, obround, or elliptical shape.
[6] The aluminum wiring material according to any one of [1] to [5], wherein an aluminum content in the aluminum wiring material is 99 mass % or more and less than 99.9 mass % relative to the total amount of the aluminum wiring material.
[7] A method for manufacturing an aluminum wiring material, the method including:

preparing an aluminum alloy that has a purity of less than 99.9 mass % and contains, relative to the total amount thereof, at least one element of iron (Fe) and silicon (Si) in a total amount of 0.01 mass % or more and 1 mass % or less, and at least one element of gallium (Ga) and vanadium (V) in a total amount of 50 mass ppm or more and 800 mass ppm or less; and
subjecting the aluminum alloy to wire drawing, wherein
in a cross section perpendicular to a longitudinal direction of the aluminum wiring material,
an orientation ratio of a crystal orientation <112> having an angular difference of 10° or less with respect to the longitudinal direction of the aluminum wiring material is 45% or less,
a ratio of the number of precipitated particles having an aspect ratio of 4 or more to the total number of precipitated particles of the aluminum wiring material is 0.5% or more and 16% or less,
a load stress ratio defined by the following expression (1) is 0.4 or more and 0.9 or less:

load stress ratio = fatigue limit/tensile strength (1), and
a proof stress ratio defined by the following (2) is greater than 1.0 and 2.3 or less:
proof stress ratio = maximum stress/0.2% proof stress (2).

[8] A method for manufacturing an aluminum wiring material, the method including:

preparing an aluminum alloy that has a purity of less than 99.9 mass % and contains, relative to a total amount thereof, at least one element of iron (Fe) and silicon (Si) in a total amount of 0.01 mass % or more and 1 mass % or less, and at least one element of gallium (Ga) and vanadium (V) in a total amount of 50 mass ppm or more and 800 mass ppm or less; and

subjecting the aluminum alloy to wire drawing so that an area reduction ratio (working ratio) per die is 5% or more and 40% or less, wherein

in a cross section perpendicular to a longitudinal direction of the aluminum wiring material,

an orientation ratio of a crystal orientation <112> having an angular difference of 10° or less with respect to the longitudinal direction is 45% or less,

a ratio of the number of precipitated particles having an aspect ratio of 4 or more to the total number of precipitated particles is 0.5% or more and 16% or less,

a load stress ratio defined by the following expression (1) is 0.4 or more and 0.9 or less:

load stress ratio = fatigue limit/tensile strength (1), and

a proof stress ratio defined by the following expression (2) is greater than 1.0 and 2.3 or less:

proof stress ratio = maximum stress/0.2% proof stress (2).

Note that, in the present specification, the term "x to y" indicates a range of numerical values from a value x to a value of y.

Advantageous Effects of Invention

According to the present invention, an aluminum wiring material exhibiting excellent long-term bonding reliability under a temperature cycle, excellent conformability to a wedge tool, and excellent vibration resistance can be provided. According to the present invention, a method for manufacturing an aluminum wiring material exhibiting excellent long-term bonding reliability, excellent conformability to bending, and excellent vibration resistance can be provided. With this configuration, the present invention can contribute to miniaturization of a power semiconductor and the like using the aluminum wiring material.

Brief Description of Drawings

[Fig. 1] Fig. 1 is an enlarged photograph (left side) of a bonding portion in which a wiring material is detached from a wedge tool, and a photograph (right side) of a normal bonding portion in which a wiring material is not detached from a wedge tool.
[Fig. 2] Fig. 2 is a graph of an S-N curve.
[Fig. 3] Fig. 3 is a view schematically showing an example of a cross-sectional shape of an aluminum wiring material.
[Fig. 4] Fig. 4 is a view schematically showing a simulated power semiconductor device for evaluation configured to evaluate a power cycle life and vibration fatigue in a resin-sealed state.
[Fig. 5] Fig. 5 is a view showing an observation region R of an aluminum wiring material during observation of a crack on an upper side.
[Fig. 6] Fig. 6 is a photograph of an aluminum wiring material cracked on an upper side.
[Fig. 7] Fig. 7 is a partially enlarged photograph of Fig. 6.
[Fig. 8] Fig. 8 is a photograph of an aluminum wiring material not cracked on an upper side.

Description of Embodiments

Hereinafter, an aluminum wiring material of an embodiment of the present invention will be described.
The aluminum wiring material of the present embodiment is an aluminum wiring material made of aluminum having a purity of less than 99.9 mass %, and an orientation ratio of a crystal orientation <112> having an angular difference of 10° or less with respect to a longitudinal direction of the aluminum wiring material is 45% or less in a cross section perpendicular to the longitudinal direction.
The present inventors produced a plurality of wiring material samples on a trial basis from aluminum having different chemical compositions under different manufacturing conditions, evaluated the long-term bonding reliability (hereinafter also referred to as "power cycle life") of each of the samples as described below, and carefully observed a cross-sectional structure of each wiring material sample perpendicular to its longitudinal direction. As a result, the inventors have found a correlation between the abundance ratio of a specific crystal orientation and a power cycle life. That is, the inventors have found that when the abundance ratio of a crystal orientation <112> having an angular difference of 10° or less with respect to the longitudinal direction of each wiring material among crystal orientations in the cross section perpendicular to the longitudinal direction falls within a certain range, the power cycle life is remarkably excellent.

In processes of manufacturing aluminum wiring materials including an aluminum wiring material that is used for conduction of a semiconductor package, the ratio of a crystal orientation <111> is variously controlled. When the ratio of the crystal orientation <111> is controlled, a soft wire product having satisfactory workability can be used in practice. However, it has been found that, in an aluminum wiring material used for conduction in recent compact and thin semiconductor packages, controlling only the ratio of the crystal orientation <111> cannot solve the problem of simultaneously achieving improvements in long-term bonding reliability under a temperature cycle, conformability to a wedge tool, and vibration resistance as described above. Therefore, the inventors have considered that mixing a specific crystal orientation having higher deformation resistance than the crystal orientation <111> in terms of properties of metal structure to optimize the ratio of the crystal orientation is important to solve the above-mentioned problem. The inventors have found that when the abundance ratio of a crystal orientation <112> among the specific crystal orientations is controlled within a certain range, the problem as described above can be solved. That is, by maintaining the ratio of the crystal orientation <112> within a predetermined range and additionally adjusting other properties of the wiring material in combination, it has become possible, through the synergistic effects thereof, to maintain vibration resistance and conformability to a wedge tool while particularly achieving an extended power cycle life.

Specifically, when the abundance ratio of the crystal orientation <112> having an angular difference of 10° or less with respect to the longitudinal direction among crystal orientations in the cross section perpendicular to the longitudinal direction in the aluminum wiring material of the present embodiment is 45% or less, an excellent power cycle life is achieved, and high vibration resistance, which will be described later, can be simultaneously achieved. From the viewpoints of these, the abundance ratio of the crystal orientation <112> is preferably 10% or more and 40% or less, and more preferably 15% or more and 35% or less.

(Evaluation of power cycle life)

A power cycle test is a test in which a cycle is repeatedly performed that includes energizing an aluminum wiring material so that the surface temperature of a power chip bonded to the aluminum wiring material reaches 150°C, stopping the energization, and then cooling the aluminum wiring material until the surface temperature decreases to 25°C. That is, the power cycle test is a test in which a cycle of rapid cooling and rapid heating at a temperature difference of 125°C is repeatedly performed and the number of operations of the cycle until the power chip causes an operational problem is evaluated. The cycle number when energization becomes impossible is determined as the sample life determined by the power cycle test (power cycle life). As the power cycle life is longer, the long-term bonding reliability is more excellent.

Next, the inventors carefully observed a metal structure in a cross section perpendicular to the longitudinal direction of each of wiring material samples produced as described above. As a result, the inventors have found that precipitated particles on an aluminum-based matrix differ in shape (when it is approximated to an ellipse, an aspect ratio of a major axis and a minor axis) and the distribution of aspect ratio of the precipitated particles depending on the chemical compositions and manufacturing conditions of the wiring material samples.

The inventors presumed that the presence of precipitated particles with a specific aspect ratio among the precipitated particles observed in the cross section perpendicular to the longitudinal direction is related to the conformability of the wiring material. Based on this presumption, the investors analyzed photographs of the precipitated particles taken by backscattered electron imaging in a scanning electron microscope (SEM-BEI) using an image processing software to conduct a quantitative evaluation of the precipitated particles in the images. A quantitative evaluation method will be described below in detail. The inventors have found that the aspect ratio of the precipitated particles observed in the cross section perpendicular to the longitudinal direction of the wiring material and the distribution of aspect ratio are related to the conformability of the wiring material.

The aluminum wiring material of the present embodiment has a ratio of the number of precipitated particles having an aspect ratio of 4 or more to the total number of precipitated particles in the cross section perpendicular to the longitudinal direction of 0.5% or more and 16% or less. From the viewpoint of improving conformability, the ratio of the number of the precipitated particles having an aspect ratio of 4 or more is preferably 0.7% or more and 12% or less, and more preferably 1% or more and 8% or less.

The precipitated particles are particles having a size (maximum particle length) of about 30 $\mu$m or less and lump, ring, plate, needle, substantially spherical, and irregular shapes. The particles are considered to include particles crystallized or precipitated during the manufacturing process and particles contained in an aluminum raw material. In addition, the precipitated particles are considered to include any one or two or more types of precipitates of an alloy or an intermetallic compound of aluminum and iron, an alloy or an intermetallic compound of aluminum, iron, and silicon, and elemental silicon.

The number of the precipitated particles and the distribution of aspect ratio of the precipitated particles can be controlled by the chemical composition of the wiring material (the content ratios of iron and silicon), heat treatment temperature, time, timing of heat treatment, wire drawing conditions, and the like. It is preferable that the objectivity of measurement data be ensured in selection of a measurement area. In this method, it is preferable that the sample for measurement be taken from the wiring material to be measured at intervals of, for example, 3 to 5 m in the longitudinal direction of the wiring material, and then subjected to measurement. When it is difficult to take samples at such intervals, for example, when the wiring material is short, shorter intervals may be adopted as long as the objectivity of the measurement data can be ensured.

The number of the precipitated particles and the distribution of aspect ratio of the precipitated particles can be observed as described below. The observation sample is made in a state in which an observation surface is exposed by mounting and polishing, and roughness and contamination of the sample surface are eliminated by buffing and a milling treatment (the surface is extremely clean). The precipitated particles are identified with a field emission scanning electron microscope (FE-SEM, SU8220 manufactured by Hitachi High-Tech Corporation) at a magnification of 1,000, the acceleration voltage is then set to 5 kV, the working distance (W.D.) is set to 10 mm, and the precipitated particles are observed in a backscattered electron image (BED-C). Specifically, the precipitated particles within a wide range of the cross section are observed at a magnification of 400, and among the precipitated particles, the precipitated particles at 1 to 3 locations where the particle distribution is uniform are observed at a magnification of 1,000. When a location where the particle distribution is uniform is difficult to identify at a magnification of 1,000, it is preferable that the precipitated particles be observed at about three locations at a magnification of 1,000. When the precipitated particles are observed at a plurality of locations as described above, it is preferable that the average value of those observed at the observation locations be set to the value of aspect ratio. When the entirety of the sample is tried to be observed, the sample may be observed at a magnification of 400, but it is desirable that a sample having fine particles be observed at a magnification of 1,000 rather than 400. In this regard, the observation magnification may be appropriately selected by a measurer according to the wire diameter and the particle size, and from the viewpoint of measurement accuracy, a more accurate value can be obtained by observation at a magnification of 1,000. That is, it is preferable that the precipitated particles be observed at a magnification of 400 or more and 1,000 or less, and it is more preferable that the magnification be higher within this range. Further, in the FE-SEM observation, the observation conditions for photographing are adjusted so that the precipitated particles and the aluminum matrix can be clearly distinguished in the obtained image. Furthermore, mapping and point analysis at some locations are performed using EDX (Flat QUAD manufactured by Bruker Corporation) attached to the same device to confirm that the precipitated particles detected in the FE-SEM image at a magnification of 1,000 are an element (or an alloy) different from the aluminum matrix, and portions having the same contrast (brightness) are considered to have the same element (or alloy) composition. In image data (TIFF file, data size: 1 M or more, $1,280 \times 1,024$ pixels or more) obtained by FE-SEM observation of a lateral cross section perpendicular to the wire axis of the aluminum wiring material, for example, precipitated particles having a smaller atomic weight (density) than aluminum are displayed as pixels with a high brightness value due to the difference of the chemical composition between the aluminum wiring material and a region other than the aluminum wiring material. In this case, a region other than the precipitated particles (the aluminum matrix) is displayed with a low brightness value. This FE-SEM image is normalized so that the brightness value falls within the range of 0 to 1 for easy discrimination of the precipitated particles. After that, a threshold of the brightness value (for example, 0.95) capable of separating the precipitated particles from the region other than the precipitated particles is determined using a histogram and the like, and the brightness value is binarized into 1 and 0 on the basis of the threshold. Thus, a region where the brightness value is 0 is displayed in black, and a region where the brightness value is 1 is displayed in white. The number of regions observed as the precipitated particles (regions where the brightness value is 1) and the aspect ratio of each of the regions on the processed image in which the brightness value is binarized into 1 and 0 are calculated using an image analysis program (e.g., an image analysis program written in MATLAB). From the calculated number of the precipitated particles and the calculated aspect ratio of each of the precipitated particles (the distribution of aspect ratio), a ratio of the number of the precipitated particles having an aspect ratio of 4 or more to the total number of the precipitated particles is calculated. The regions observed as the precipitated particles are approximated to an ellipse, and a value of the major axis/the minor axis of the ellipse is calculated as the aspect ratio of each of the precipitated particles. The precipitated particles can be approximated to an ellipse by a least-squares method using center coordinates of the precipitated particles and coordinates of respective points of the outer periphery of the regions of the precipitated particles. When the identification of the precipitated particles by FE-SEM is particularly difficult, binarization may be performed using an EDX mapping image, but it is desirable that the precipitated particles be identified using FE-SEM.

Further, it has been found that, since the crystal grains in the crystal structure of the aluminum wiring material of the present embodiment are fine, the elasticity of the crystal structure is increased, which, in combination with the abundance ratio of the <112> orientation ratio described above, further improves the conformability to a wedge tool. Specifically, in the aluminum wiring material of the present embodiment, the average crystal grain diameter in the cross section perpendicular to the longitudinal direction is preferably 40 μm or less, and in this case, the conformability to a wedge tool is easily achieved. The average crystal grain diameter is preferably 30 μm or less, and more preferably 20 μm or less. The average crystal grain diameter is generally 1 μm or more.

In measurement and analysis of the crystal structure in the cross section of the aluminum wiring material, an electron backscatter diffraction pattern (hereinafter referred to as "EBSP") method can be used. Even for fine wires, such as wiring materials for semiconductor bonding, the crystal structure in the cross section can be accurately measured by the EBSP method with sufficient reproducibility.

When the roughness and curve of the surface of a sample are large, the EBSP method is difficult to measure the crystal orientation with high accuracy. Accordingly, it is useful to smoothen the surface of the cross section for observation of the cross section of the wiring material by EBSP. Examples of the method for smoothening the surface of the cross section include mechanical polishing, chemical polishing, and FIB processing. According to these methods, a residual strain of the surface of the cross section can be removed to obtain a smooth surface.

When the sample is appropriately pre-treated as describe above, the crystal orientation in the cross section of the wiring material can be measured and analyzed by the EBSP method with high accuracy. The measurement of the crystal orientation is performed at at least 3 or more locations, or if possible, at 10 or more different locations, so that an average value that accounts for variation can be obtained.

(Load stress ratio)

In the aluminum wiring material of the present embodiment, a load stress ratio defined by the following expression (1) is 0.4 or more and 0.9 or less:

```
Load stress ratio = fatigue limit/tensile strength   (1)
```

It is known that vibration randomly occurs in three axial directions of X, Y, and Z when a vehicle travels or a human walks, and the vibration frequency is 40 Hz or less in many cases. For example, an aluminum wiring material mounted on an electric vehicle is stretched, compressed, or bent in the three axial directions over an extended period of time by stress as described above. The inventors studied a method for evaluating performance against a vibration load with complex directionality as described above. As a result, the inventors have found that the vibration resistance as described above correlates with the load stress ratio represented by the expression (1) described above.

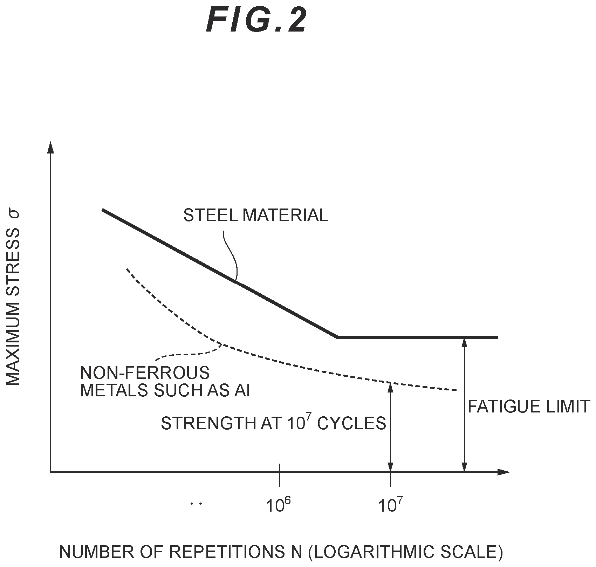

In general, when a steel material is subjected to a cyclic stress with a constant amplitude, it fractures due to fatigue after a certain number of cycles. An S-N curve shown in Fig. 2 is represented by a graph of two axes in which a Y axis is the magnitude of cyclic stress and an X axis is the number of cycles. As the cyclic stress is reduced, the S-N curve becomes horizontal at $10^6$ to $10^7$ cycles, and fracture does not occur even under application of infinite-times cyclic stress. The value of the cyclic stress in this state is referred to as fatigue limit. On the other hand, an S-N curve of a nonferrous metal, such as aluminum, has no horizontal portion as shown in Fig. 2, and fatigue limit is not present. Therefore, the strength at a certain number of cycles is considered as fatigue limit. For example, the cyclic stress in which fracture does not occur up to $10^7$ cycles is referred to as strength at $10^7$ cycles. The stress amplitude when the number of cycles is about $10^7$ to $10^8$ may conventionally be considered as fatigue limit, and hence, in the present embodiment, the strength at $10^7$ cycles is considered as fatigue limit.

The fatigue limit is generally expressed as maximum load stress (MPa). A fatigue limit in the present invention can be measured by performing a tensile fatigue test at room temperature (e.g., 25°C) using a test machine dedicated to tensile fatigue tests (Electro Plus E3000 manufactured by Illinois Tool Works, Inc., hereinafter referred to as "measurement device"), in accordance with the principles of JIS Z 2273:1978 as described below. An aluminum wiring material to be evaluated is cut into a length of slightly more than 100 mm to obtain an evaluation sample having a measurement length of 100 mm. For calculation of a value of maximum load stress to be described later, the value of the 0.2% proof stress of the aluminum wiring material to be evaluated is obtained in advance in a tensile test. Subsequently, the evaluation sample is fixed to the measurement device, and loading at the maximum load stress and unloading at the minimum load stress are repeated at a speed of 5 Hz (5 cycles per second) for cycles exceeding $10^7$ (tensile fatigue test). Here, the maximum load stress is a value of 90% of the 0.2% proof stress and an optional value less than 90% of the 0.2% proof stress, and the minimum load stress is 10 MPa (fixed value). The value of 90% of the 0.2% proof stress is set to a maximum value, the optional value less than 90% of the 0.2% proof stress is set in descending order, and the loading and the unloading are repeated for three or more different load cycles. The results are plotted on a semi-logarithmic graph in which an x axis is the number of load cycles, a y axis is the maximum load stress $\sigma$, and the x axis is on a logarithmic scale (the base of the logarithm: 10), to create an S-N curve. In the tensile fatigue test, the test conditions are adjusted so that the interval between the numbers of load cycles plotted on the graph in the x axis direction is 1 or more on a logarithmic scale or $10^1$ or more when expressed on a linear scale. An approximated straight line is obtained from the plotted points by the least squares method, and the maximum load stress at which fracture does not occur at $10^7$ load cycles is determined from the approximated straight line. The maximum load stress when fracture does not occur at $10^7$ load cycles becomes the fatigue limit (MPa).

When evaluation at $10^7$ or more load cycles is difficult, for example, three or more maximum load stresses when fracture does not occur at $10^3$ or more and $10^6$ or less load cycles are plotted on the semi-logarithmic graph of the S-N curve, an approximated straight line is determined by the least squares method from the plotted points, and a fatigue limit at $10^7$ load cycles may be estimated from the approximated straight line. Also in this case, test conditions are adjusted so that the interval in the x axis direction of the plotted points is 1 or more when expressed on a logarithmic scale or $10^1$ or more when expressed on a linear scale. It is important that this tensile fatigue test satisfies three conditions described below to perform the test more accurately.

(i) Both ends of the measurement length (a stretched portion) are fixed and are not moved during the test.
(ii) Both ends of the measurement length are straightly stretched in an axial direction.
(iii) In the tensile test, fracture does not occur at a chuck portion.

Next, the tensile strength will be described. The tensile strength is obtained by dividing the maximum load (kgf) when an evaluation sample is applied with tension at both ends thereof with a tensile testing device by the cross-section area of the wiring material. This maximum load is automatically calculated by converting a tensile force to an electrical signal using the tensile testing device. The load stress ratio is determined as a value of fatigue limit/tensile strength as described in the expression (1), but may be determined as a value of the maximum load in the tensile fatigue test/the maximum load in the tensile test.

In the aluminum wiring material of the present embodiment, when the load stress ratio is 0.4 or more and 0.9 or less, fracture caused by vibration at a neck portion of the wiring material bonded to a semiconductor chip is remarkably suppressed, and as a result, vibration resistance can be improved. The load stress ratio is preferably 0.5 or more and 0.9 or less, more preferably 0.6 or more and 0.9 or less, and still more preferably 0.7 or more and 0.9 or less. When the load stress ratio falls within the range, an effect of vibration resistance can be enhanced.

(Proof stress ratio)

In the aluminum wiring material of the present embodiment, the proof stress ratio defined by the following expression (2) is greater than 1.0 and 2.3 or less:

Proof stress ratio = maximum stress/0.2% proof stress (stress) (2)    (2)

When the load stress ratio is set within the above-mentioned range and the proof stress ratio of the aluminum wiring material is adjusted to be greater than 1.0 and 2.3 or less, the toughness of the aluminum wiring material increases, and its vibration resistance can be further improved. The proof stress ratio is preferably 1.2 or more and 2.1 or less, and more preferably 1.4 or more and 1.9 or less.

The proof stress ratio is a value obtained by dividing the maximum stress (MPa) by the 0.2% proof stress (stress) (MPa). In the above-mentioned tensile test, the maximum load (kgf) and the 0.2% strain load (kgf) of the wiring material are first determined. The maximum stress (MPa) is obtained by dividing the maximum load by the cross-section area of the wiring material. The 0.2% proof stress (stress) (MPa) is obtained by dividing the 0.2% strain load by the cross-section area of the wiring material. That is, the maximum stress is maximum load/cross-section area, and the 0.2% proof stress (stress) is 0.2% strain load/cross-section area. The results can be applied to the expression (2) to calculate the proof stress ratio. The proof stress ratio may be calculated as a value of the maximum load in the tensile test/the 0.2% strain load.

(Evaluation of vibration resistance)

Each of the wiring material samples is bonded to two aluminum plates at each of a first bonding portion and a second bonding portion with an ultrasonic bonding apparatus (Wire Bonder REBO7 manufactured by Ultrasonic Engineering Co., Ltd.) so that the height and the length of a loop are 1 mm and 7 mm, respectively, to obtain an evaluation sample. Using this evaluation sample, a vibration fatigue test was performed using a test machine dedicated to vibration fatigue manufactured on the basis of JIS (e.g., CV-101M manufactured by AS ONE Corporation), so that vibration resistance is evaluated. In the vibration fatigue test, vibration at a frequency of 50 Hz, an acceleration speed of 1 G, and an amplitude of 0.099 mm is applied to each sample until fracture. In the vibration fatigue test, as the total number of vibration until fracture is larger, the vibration resistance is more excellent.

As described above, for example, an electric vehicle is sometimes operated in a region where the road surface maintenance is not sufficient and the evenness of the road is low, and hence a power semiconductor mounted on the electric vehicle is required to cause no failure by vibration. The aluminum wiring material of the present embodiment has excellent vibration resistance due to the configuration described above, and hence failure caused by exposure to long-time vibration can be suppressed. Further, in a power semiconductor, vibration as described above is applied under a temperature cycle caused by current. However, owing to the above configuration, the aluminum wiring material of the present embodiment exhibits a remarkably reduced occurrence of failures such as fracture, even when both a temperature cycle and vibration are simultaneously applied. Therefore, when the aluminum wiring material is used in the electric vehicle, high safety can be realized.

In ultrasonic bonding, which is a method for bonding an aluminum wiring material, an ultrasonic wave is applied to the aluminum wiring material while a load is applied thereto, thereby breaking an oxide film or the like on the bonding surface and bonding the wiring material while deforming it. Therefore, as an oxide film or the like on the surface of a bus bar or an electrode, which is a bonding target, is thicker, an ultrasonic wave applied to the aluminum wiring material for removal of the oxide film uses higher load and higher energy. However, when an ultrasonic wave of high load and high energy is applied, vibration caused by the application reduces the strength of the wiring material particularly near the boundary of the bonding portions, and as a result, the long-term bonding reliability is easily reduced. In the aluminum wiring material of the present embodiment, excellent vibration resistance and power cycle life can be achieved as described above. Therefore, even in the aluminum wiring material in which bonding is performed by an ultrasonic wave of high load and high energy, long-term bonding reliability can be maintained.

Since resistance to vibration under low loop bonding is lower than that under high loop bonding, failure of the aluminum wiring material or the bonding portions thereof has conventionally been suppressed by maintaining a predetermined loop height. The aluminum wiring material of the present embodiment has excellent vibration resistance, and hence bonding at a lower loop height can be achieved, which can contribute to miniaturization of a power semiconductor. In IGBT, MOSFET, and the like, a wiring material and a semiconductor chip are generally sealed with a resin. However, the sealing resin and the wiring material or the semiconductor chip are not completely brought into close contact with each other, and there is a gap between the resin and the wiring material or the semiconductor chip throughout. Due to the gap, a power semiconductor sealed with a resin is required to have vibration resistance similarly to a power semiconductor not sealed with a resin. In a wiring material that causes thermal fatigue under a temperature cycle, vibration with a short amplitude caused by a slight gap between a resin and the wiring material may cause failure. However, the aluminum wiring material of the present embodiment has a long power cycle life and excellent vibration resistance, and hence the power semiconductor sealed with a resin can also suppress fracture caused by a temperature cycle or vibration.

Aluminum constituting the aluminum wiring material of the present embodiment contains, relative to the total amount thereof, at least one element of iron (Fe) and silicon (Si) in a total amount of 0.01 mass % or more and 1 mass % or less, and at least one element of gallium (Ga) and vanadium (V) in a total amount of 50 mass ppm or more and 800 mass ppm or less.

Since the aluminum wiring material of the present embodiment contains these elements, the distribution of the precipitated particles described above can be obtained by adjusting the manufacturing conditions. Therefore, the aluminum wiring material of the present embodiment can exhibit excellent vibration resistance and long-term bonding reliability. Iron, silicon, gallium, and vanadium may be included in the raw material of the aluminum wiring material in advance, or may be added in the manufacturing process of the aluminum wiring material.

In the aluminum wiring material of the present embodiment, when the total amount of at least one element of iron and silicon is 0.01 mass % or more, a longer power cycle life can be obtained. The total amount of iron and silicon is preferably 0.02 mass % or more, more preferably 0.05 mass % or more, still more preferably 0.1 mass % or more, and further more preferably 0.13 mass % or more, because it is easy to achieve a long power cycle life. The total amount of iron and silicon is more preferably 0.9 mass % or less, and still more preferably 0.8 mass % or less, because it is possible to maintain electrical conductivity while achieving a long power cycle life.

In the aluminum wiring material of the present embodiment, the amount of iron, relative to the total amount of the aluminum alloy, is preferably 0.01 mass % or more, more preferably 0.03 mass % or more, still more preferably 0.05 mass % or more, particularly preferably 0.1 mass % or more, and more particularly preferably 0.13 mass % or more. The amount of iron is preferably 0.95 mass % or less, and more preferably 0.9 mass % or less, relative to the total amount of the wiring material. The amount of silicon is preferably 0.01 mass % or more, and more preferably 0.05 mass % or more, relative to the total amount of the aluminum alloy. The amount of silicon is preferably 0.5 mass % or less, and more preferably 0.4 mass % or less. By combining the above-described preferred ranges of iron and silicon, the long-term bonding reliability can be more easily obtained by the synergistic effect of iron and silicon.

In the aluminum wiring material of the present embodiment, the upper limit of the content of at least one type of gallium and vanadium is not particularly limited, but is about 1000 mass ppm. The total amount of gallium and vanadium is preferably 800 mass ppm or less, which makes it easy to suppress the maximum attainable temperature reached by the aluminum wiring material during energization. The content of gallium and vanadium may be 100 mass ppm or more, or 150 mass ppm or more, relative to the total amount of the wiring material. The content of gallium and vanadium may be 700 ppm by mass or less, or 600 ppm by mass or less, relative to the total amount of the wiring material. When only one of gallium and vanadium is contained in the wiring material, the content of either gallium or vanadium may be within the above-described range. When both gallium and vanadium are contained, the total amount of gallium and vanadium may be within the above-described range.

For example, in the case where an aluminum wiring material having a purity of 99.99 mass % is used and the maximum attainable temperature during energization is 150°C, the maximum attainable temperature can be suppressed to 160°C or lower when the content of gallium and vanadium is 1000 mass ppm or less. That is, the exothermic rise temperature during energization can be suppressed by about 10°C or lower based on the aluminum wiring material having a purity of 99.99 mass %.

In addition to iron, silicon, gallium, and vanadium, the aluminum wiring material of the present embodiment may contain one or more types of trace elements of magnesium (Mg), copper (Cu), nickel (Ni), zinc (Zn), chromium (Cr), manganese (Mn), titanium (Ti), zirconium (Zr), tungsten (W), and scandium (Sc). The aluminum wiring material of the present embodiment may contain unavoidable impurities other than the above-mentioned trace elements. The total content of the trace elements is 0.1 mass % or less relative to the entire wiring material. The content of the trace elements is, for example, 0.0001 mass % or more relative to the total amount of the aluminum alloy. These trace elements may be contained in advance in the raw material of the aluminum wiring material, may be unavoidable impurities of the aluminum raw material, or may be added during the manufacturing process of the aluminum wiring material. The content of the above-described trace elements is preferably 0.005 mass % or more, more preferably 0.01 mass % or more, and still more preferably 0.015 mass % or more.

In general, the content ratio of the elements contained in the aluminum wiring material of the present embodiment is measured by chemical analysis such as inductively coupled plasma (ICP) optical emission spectrometry, but is not limited thereto. For example, the content ratio may be similarly measured by secondary ion mass spectrometry (SIMS), glow discharge mass spectrometry (GDMS), or energy dispersive X-ray spectrometry (EDX).

The aluminum wiring material of the present embodiment is preferably made of an aluminum alloy having an aluminum purity (the amount of aluminum relative to the total amount of the aluminum wiring material) of 99 mass % or more. This makes it possible to impart a sufficient electrical conductivity to the material and further excellent vibration resistance and long-term bonding reliability. The aluminum purity of the aluminum wiring material is preferably 99.9 mass % or less. Since aluminum having a aluminum purity of 99.9 mass % or less can contain sufficient amounts of iron, silicon, gallium, vanadium, and trace elements, it contributes to improvement in long-term reliability. The purity of the aluminum alloy is more preferably less than 99.9 mass %, and still more preferably less than 99.8 mass %.

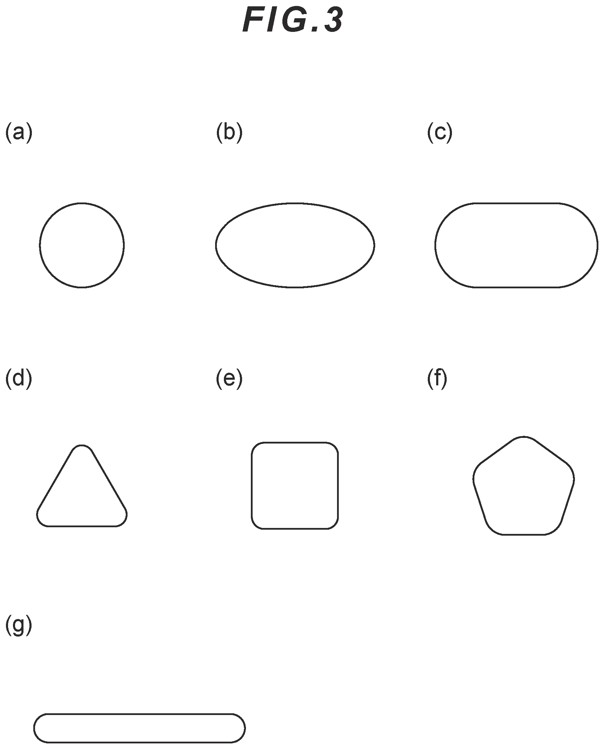

The wire diameter of the aluminum wiring material of the present embodiment is usually 15 μm or more and 700 μm or less, preferably 70 μm or more and 600 μm or less, and more preferably 100 μm or more and 500 μm or less. The wire diameter of the aluminum wiring material is defined as the diameter thereof if the cross-sectional shape is a perfect circle. Alternatively, the length of the major axis is defined as the diameter if the cross-sectional shape is any other shape (circular, elliptical, obround, polygonal, or polygon-like shape in cross-section as shown below). However, if the cross-sectional shape is a polygon or a shape similar to a polygon, the length may be measured as the width or thickness. Fig. 3 schematically shows an example of the cross-sectional shape of the aluminum wiring material. As shown in Fig. 3, the cross-sectional shape of the aluminum wiring material may be an elliptical shape (e.g., b in Fig. 3), an obround shape (e.g., c in Fig. 3), a rectangular shape (e.g., e in Fig. 3), a triangle (e.g., d in Fig. 3) or a shape similar to a polygon (e.g., f and g in Fig. 3), in addition to a circular shape (a in Fig. 3). When the cross section of the aluminum wiring material is elliptical or obround, the length of the major axis is preferably 0.3 mm or more and 4 mm or less, more preferably 0.5 mm or more and 3 mm or less, and the length of the minor axis is preferably 0.05 mm or more and 0.5 mm or less, more preferably 0.1 mm or more and 0.5 mm or less. When the cross section of the aluminum wiring material is rectangular, the length of the long side is preferably 0.3 mm or more and 4 mm or less, more preferably 0.5 mm or more and 3 mm or less, and the length of the short side is usually 0.05 mm or more and 0.5 mm or less, more preferably 0.1 mm or more and 0.5 mm or less. Note that a wiring material having a cross section of a polygon, a shape similar to a polygon, or a flat ellipse (a shape obtained by compressing an ellipse in a uniaxial direction) is referred to as a ribbon, and a wiring material having a cross section of a circle, ellipse or obround is referred to as a wire.

(Method for manufacturing aluminum wiring material)

Next, an example of a method for manufacturing the aluminum wiring material according to the embodiment will be described. Note that the method for manufacturing the aluminum wiring material is not limited to the following manufacturing method. It is desirable to appropriately adjust the conditions in view of the weight of the aluminum wiring material to be manufactured and the processing capacity of a heat treatment furnace.

Aluminum having a high purity of 99 mass % or more is melted together with iron and silicon to prepare aluminum melt. The purity of the high-purity aluminum used as a raw material may be 99.9 mass % or more, and may be 99.99 mass % or more. For the melting, a heating furnace such as an arc heating furnace, a high-frequency heating furnace, a resistance heating furnace, or a continuous casting furnace is used. Although melting in the atmosphere does not cause any problem, in order to prevent contamination with oxygen and hydrogen from the atmosphere, the aluminum melt in the heating furnace may preferably be melted while being held in a vacuum or in an inert gas atmosphere such as argon, nitrogen, or the like. When melting aluminum, it is preferable to perform an inclusion removal step in which the aluminum melt is bubbled with an inert gas such as argon (Ar) or nitrogen, followed by a filtration treatment using a filter. In the inclusion removal step, inclusions such as silicon dioxide ($SiO_2$) and aluminum oxide ($Al_2O_3$) are caused to aggregate on the surface of the aluminum melt by bubbling with the inert gas, and then removed from the aluminum melt by the subsequent filtration treatment. By removing the inclusions, it becomes easy to adjust the load stress ratio to 0.4 or more. When argon (Ar) gas is used in the inclusion removal step, it becomes easy to adjust the proof stress ratio and <112> orientation ratio to above-mentioned ranges while increasing the load stress ratio, and so it is possible to further improve the long-term bonding reliability under temperature cycles and vibration resistance.

In addition, since the removal effect of inclusions increases as the flow rate of gas for bubbling is increased and the bubbling time is prolonged in the inclusion removal step, the load stress ratio can be easily adjusted to 0.4 or more. On other hand, when the gas flow rate is excessively high or the bubbling time is excessively long, the effect becomes insufficient after the inclusion removal effect reaches its limit, resulting in waste. As a bubbling method, it is preferable to bubble an inert gas through a pipe made of steel exhibiting excellent corrosion resistance at high temperatures, from the viewpoint of suppressing elution of impurities into the aluminum melt. As a filtration treatment method, there is a method in which the aluminum melt is passed through a filter made of ceramic foam having a porosity of about 0.8 to 0.9.

Table 1 shows the differences in the load stress ratio, proof stress ratio, and <112> orientation ratio of the aluminum wiring material having the final wire diameter, between the case where the inclusion removal step was performed (with bubbling) and the case where it was not performed (without bubbling), under common manufacturing conditions. In the experimental examples shown in Table 1, the effects of the presence or absence of bubbling were compared for a chemical composition A, which contained 0.15 mass % of iron (Fe), 0.03 mass % of Si (silicon), 0.009 mass % of Ga (gallium) and 0.012 mass % of vanadium (V) with the balance being aluminum and unavoidable impurities, and a chemical composition B, which contained 0.8 mass % of iron (Fe), 0.2 mass % of Si (silicon), 0.03 mass % of Ga (gallium) and 0.03 mass % of vanadium (V) with the balance being aluminum and unavoidable impurities. As shown in Table 1, it is understood that the load stress ratio, proof stress ratio, and <112> orientation ratio can be adjusted more easily to fall within the respective ranges of the present embodiment in the case where the inclusion removing step was performed in the aluminum melt than in the case where the step was not performed.

[Table 1]

| | CHEMICAL COMPOSITION A ※ 1 | | | CHEMICAL COMPOSITION B ※ 2 | | |
|---|---|---|---|---|---|---|
| | LOAD STRESS RATIO | PROOF STRESS RATIO | <112> ORIENTATION RATIO | LOAD STRESS RATIO | PROOF STRESS RATIO | <112> ORIENTATION RATIO |
| WITH BUBBLING | 0.76 | 1.65 | 16% | 0.81 | 1.72 | 20% |
| WITHOUT BUBBLING | 0.45 | 2.23 | 42% | 0.55 | 2.11 | 39% |
| ※ 1: Al-0. 15%Fe-0. 03%Si-0. 009%Ga-0. 012%V | | | | | | |
| ※   2   :   Al-0.   8%Fe-0.   2%S   i-0.   03%Ga-0.   03%V | | | | | | |

The aluminum melt material can be continuously cast from the heating furnace and solidified into a predetermined diameter to make an ingot, and the ingot can be set in an extruder and extrusion-molded so as to have a predetermined wire diameter. In the method for manufacturing an aluminum wiring material of the present embodiment, it is preferable to perform an anti-scratch treatment step of subjecting the starting wire rod, which was extrusion-molded into the predetermined wire diameter, to an anti-scratch treatment. After the anti-scratch treatment step, the proof stress ratio is easily adjusted to be greater than 1.0 and 2.3 or less. The anti-scratch treatment can be performed by applying a treatment liquid, which contains a surfactant as a main component, to the surface of the starting wire rod. When the surfactant is used, the surface of the starting wire rod is less likely to corrode than when an oil-based treatment liquid is used, and baking and high-temperature corrosion of the surfactant on the surface of the aluminum wiring material in a subsequent heat treatment step can be suppressed. Therefore, the proof stress ratio is easily adjusted within the above-mentioned range. After the anti-scratch treatment step, the <112> orientation ratio and the load stress ratio are easily adjusted to 45% or less and within the range of 0.4 or more and 0.9 or less, respectively, while the proof stress ratio is adjusted within the above-mentioned range. Examples of the surfactant contained in the treatment liquid of the anti-scratch treatment step include alcoholic solvents, such as ethanol, methanol, butanol, n-propyl alcohol, phenol, ethylene glycol, tridecanol, and glycerin. When a surfactant is used as a lubricant in the subsequent wire drawing step, the same type of surfactant as that used in the wire drawing step is preferably used. The concentration of the surfactant used in the anti-scratch treatment step is not particularly limited. When the surfactant is used in the subsequent wire drawing step, the concentration is preferably the same as the concentration of the surfactant in the wire drawing step in terms of easily adjusting the proof stress ratio to be greater than 1.0 and 2.3 or less.

The wire rod obtained in the above-mentioned step is subjected to wire drawing so as to obtain an intermediate wire rod having a wire diameter of 5.0 mm. The wire diameter of the intermediate wire rod is generally about 7 to 330 times the final wire diameter.

Next, the wiring material after wire drawing (intermediate wire rod) may be subjected to a homogenization treatment (homogenization treatment step). In the homogenization treatment, the intermediate wire rod is subjected to a heat treatment for heating at 400°C to 500°C for 30 minutes to 240 minutes in an air furnace, and then quenched. After the homogenization treatment step, when the amount of elements other than aluminum in the aluminum wiring material is particularly small, both the orientation ratio of the predetermined crystal orientation <112> and the load stress ratio are easily achieved. Quenching in the homogenization treatment step is not particularly limited, and quenching may be performed by a method in which the heated intermediate wire rod is immersed in cold water pooled in an immersion tank or the like, or a method in which cold water is applied to the heated intermediate wire rod by showering or the like. When the homogenization treatment is performed at a low temperature for a short time, elements other than aluminum can be homogeneously dispersed in the aluminum matrix as compared with a solution treatment. Therefore, both the orientation ratio of the predetermined crystal orientation <112> and the load stress ratio are easily achieved, and sufficient conformability to bending can be achieved while the long-term bonding reliability and the vibration resistance are improved.

In the method for manufacturing an aluminum wiring material of the present embodiment, a solution treatment for dissolving the elements other than aluminum in the aluminum matrix may be performed in addition to the homogenization treatment. The intermediate wire rod after the homogenization treatment may be subjected to an intermediate heat treatment before wire drawing. In the intermediate heat treatment, for example, the intermediate wire rod after the homogenization treatment is heated at 240 to 300°C for about 30 to 140 minutes, and then air-cooled. The <112> orientation ratio, the load stress ratio, and the proof stress ratio can be finely adjusted by the intermediate heat treatment. Heating the intermediate wire rod in the intermediate heat treatment includes a running heat treatment in which a wire rod is passed through a heating atmosphere, in which heating is performed to a predetermined temperature, and heat-treated, and a batch heat treatment in which a wire rod is heated in a closed furnace.

The intermediate wire rod is subjected to the homogenization treatment, the solution treatment, and the intermediate heat material, as required, and then subjected to wire drawing into a final wire diameter. In the wire drawing, the wiring material is passed through a plurality of cemented carbide dies or diamond dies in order to reduce the wire diameter of the wiring material stepwise. In order to adjust the <112> orientation ratio to 45% or less, the area reduction ratio (working ratio) per die has only to be 5% or more and 40% or less.

It is preferable that the wire drawing be performed while the dies are cooled. When the dies are cooled, an increase in temperature of the wiring material due to friction between the dies and the wiring material is suppressed. Thus, the <112> orientation ratio of the aluminum wiring material is easily adjusted to 45% or less, and a homogeneous <112> orientation ratio as a whole of the aluminum wiring material can be achieved. As a die cooling method, a method in which a coolant containing cool water is jetted to the inlet of the dies is effective. While the dies are cooled, a lubricant containing a surfactant as a main component may be introduced into the dies, and as a result, the load stress ratio is easily adjusted within the above-mentioned range. According to a method for jetting a coolant into the inlet of the dies to cool the dies, a lubricant can be mixed in the coolant and supplied. Therefore, the lubricant can also be efficiently introduced into the dies. As the flow rate of the jetted coolant at a temperature of 20°C or lower is higher in die cooling, the cooling effect is higher, and the <112> orientation ratio is more likely to be homogeneous. In contrast, when the flow rate of the coolant is too high, the cooling effect is limited, and waste is likely to be caused.

The wiring material drawn to the final wire diameter is subjected to a final heat treatment. In the final heat treatment, strain of a metal structure mainly remaining inside the wiring material is removed, and the mechanical characteristics and the like of the wiring material may be adjusted.

A method of the final heat treatment includes a running heat treatment in which a wiring material is passed through a heating atmosphere, in which heating is performed to a predetermined temperature, and heat-treated, and a batch heat treatment in which a wiring material is heated in a closed furnace. The final heat treatment in the present embodiment is preferably performed by the batch heat treatment, for example, at 150°C or higher and 400°C or lower for about 30 minutes or more and 60 minutes or less. When the final heat treatment is performed under the above-mentioned conditions, the ratio of the number of the precipitated particles having an aspect ratio of 4 or more can be adjusted to 0.5 or more and 5 or less. Specifically, as the final heat treatment temperature is higher or the final heat treatment time is longer, the ratio of the number of the precipitated particles having an aspect ratio of 4 or more is likely to be higher. As the final heat treatment temperature is lower or the final heat treatment time is shorter, the ratio of the number of the precipitated particles having an aspect ratio of 4 or more is likely to be lower.

Subsequently, the wiring material that has been subjected to the final heat treatment is preferably air-cooled. After air-cooling, the <112> orientation ratio of the aluminum wiring material is easily adjusted homogeneously to 45% or less. This is because the cooling effect in water-cooling is higher than that in air-cooling, but in air-cooling, the <112> orientation ratio is homogeneously and precisely controlled to 45% or less while the above-mentioned proof stress ratio and load stress ratio are achieved without causing contamination or defect on the surface of the aluminum wiring material as compared with water-cooling. Examples of an air-cooling method include a method in which the aluminum wiring material after the final heat treatment is allowed to stand at room temperature to be cooled slowly, and a method for jetting cold air to the surface of the aluminum wiring material. In particular, a method for jetting air or cold air to the surface of the aluminum wiring material is preferred since the <112> orientation ratio is likely to be homogeneously and stably adjusted within the above-mentioned desired range. In the case of performing the method for jetting air or cold air to the surface of the aluminum wiring material, as the temperature of air or cold air is lower or the speed of the jetted air is higher, the cooling effect is higher, and the <112> orientation ratio within the above-mentioned range is more likely to be stably obtained.

In the method for manufacturing the aluminum wiring material of the present embodiment described above, when conditions of each of the step of removing inclusions in the melt, the homogenization treatment of the starting wire rod, die cooling in the wire drawing, the final heat treatment, and air-cooling after the final heat treatment are adjusted by the above-mentioned procedures according to the amounts and types of the elements other than aluminum in the aluminum wiring material, the <112> orientation ratio, the average crystal grain diameter, the load stress ratio, the proof stress ratio, and the ratio of the number of the precipitated particles having an aspect ratio of 4 or more can be adjusted within preferable ranges.

(Applications of aluminum wiring material)

The aluminum wiring material of the present embodiment can be applied to any applications in which wiring materials made of iron-based materials, copper-based materials, and aluminum-based materials are conventionally used. Specifically, the aluminum wiring material of the present embodiment can be suitably used as conductive members for power semiconductors, conductive members for electric wires or cables, members for batteries, winding wires for generators or motors, and the like. The conductive members for power semiconductors are bonding wires or bonding ribbons for semiconductors, and the like. The members for batteries are meshes or nets for current collectors, bonding wiring materials for bonding a bus bar and a battery, and the like.

[Examples]

Examples will next be described. The present invention is not limited to the following examples.

Aluminum wiring materials of Examples were prepared as follows. A high-purity aluminum billet having a purity of 99.9 mass % or more was prepared, with which an aluminum alloy was prepared by adding iron and silicon, and gallium and vanadium, to each of wiring materials of Examples so as to have the chemical composition shown in Table 2. The aluminum alloy of each chemical composition was melted in the atmosphere. In melting the aluminum alloy, argon (Ar) gas was bubbled into the aluminum alloy melt through a steel pipe, and inclusions precipitated on the melt surface were filtered through a ceramic foam filter having a porosity of 0.85. The flow rate of argon (Ar) gas at this time was 7 L/min, and the molten metal flow during filtration was 22 kg/min. Then, a wire rod was obtained by continuous casting and extrusion molding. An ethanol aqueous solution as a surfactant was applied to the surface of the wire rod obtained by extrusion molding to prevent scratches. The resulting wire rod was drawn to an intermediate wire diameter of 5 mm. Then, the resulting intermediate wire rod in the middle of drawing was subjected to an intermediate heat treatment at 240°C to 300°C for about 30 to 140 minutes. The intermediate wire rod after the intermediate heat treatment was cooled in the air. The intermediate wire rods before and after the intermediate heat treatment were subjected to wire drawing by cold drawing using dies. In the wire drawing, the area reduction ratio (working ratio) per one diamond die was 5% or more and 40% or less. In the wire drawing by drawing using dies, the diamond dies were cooled by introducing, into the diamond dies, a lubricating liquid that contained a surfactant of the same type as the above-mentioned surfactant at the same concentration as that of the treating liquid in the scratch prevention treatment. In the preparation of the aluminum wiring material of Example, the wire rod was drawn to a final wire diameter (400 $\mu$m), with the total working ratio up to the final wire diameter being 99.36%. Furthermore, the aluminum wiring material processed to the final wire diameter was subjected to a final heat treatment in a batch-type furnace or a salt bath at 150°C to 400°C for 30 to 60 minutes. After the final heat treatment, the aluminum wiring material was air-cooled by jetting cold air, and the air-cooled aluminum wiring material was rewound onto a spool by a rewinding machine at intervals of about 300 m. Thus, the aluminum wiring material having a circular cross section was obtained.

The aluminum wiring materials of Comparative Examples were prepared as follows. In the same manner as that in Examples, aluminum billet having a purity of 99.9 mass % or more was prepared, and Fe, Si, Ga, V, and the like were added so as to have the chemical composition shown in Table 2. The aluminum wiring materials of respective Comparative Examples were prepared by changing the manufacturing conditions such as the heat treatment temperature and time at the intermediate wire diameter and the final wire diameter, the working ratio from each wire diameter to the next wire diameter, the cooling rate after the intermediate heat treatment, the area reduction ratio of each die, and the like outside the ranges of Examples described above.

(Measurement of crystal orientation and average crystal grain diameter of cross section of wiring material)

The crystal orientations of cross sections of the aluminum wiring materials of Examples and Comparative Examples were measured as follows. The aluminum wiring material was cut to prepare a plurality of evaluation samples with a length of several centimeters. The evaluation sample was stuck straight and flat on a metal (Ag plated frame) plate with careful attention paid to avoid stretching or sagging thereof. After that, the evaluation sample together with the metal plate was put into a cylindrical mold so that the metal plate became the bottom surface of the cylinder, and a resin for embedding was poured into the mold. After that, a curing agent was added to cure the resin. Subsequently, the cured cylindrical resin containing the evaluation samples was roughly polished with a polisher so as to expose a cross section (hereinafter also referred to as a lateral cross section) perpendicular to the longitudinal direction of the wiring material. The cut surface was then finished by final polishing, followed by ion milling to remove any residual strain on the polished surface, resulting in a smooth surface. The ion milling apparatus was finely adjusted so that the cut surface of the wiring material was perpendicular to the longitudinal direction of the wiring material.

The evaluation sample was attached to the sample base of a field emission scanning electron microscope (FE-SEM, manufactured by JEOL, JSM-7800F) so that the lateral cross section (i.e., the polished surface of the evaluation sample) of the wiring material of the evaluation sample was parallel to the sample base. Then, the crystal orientation and average crystal grain diameter of the lateral cross section were measured by FE-SEM at an observation magnification of 200 times, an acceleration voltage of 15 keV, a measurement area of about $420 \times 420$ $\mu$m, and a measurement interval (step size) of 1.2 $\mu$m. The crystal orientations thus obtained were analyzed using a dedicated software for crystal orientation analysis (OIM analysis manufactured by TSL, hereinafter also referred to as dedicated software).

The crystal grain discrimination conditions of the dedicated software were set, and the crystal orientation ratio of the measured sample, that is, the abundance ratio of each crystal orientation, was analyzed. Although the crystal grain discrimination conditions of the dedicated software can usually be set according to the purpose of analysis, it has little effect on the analysis result of the crystal orientation ratio. Therefore, in Examples and Comparative Examples, it was set so that, when 2 or more pixels were connected with an orientation difference of 10° or less, they are recognized as one crystal grain, and the ratio of crystal grains with orientation <112> among these was determined.

In the analysis of EBSP measurement data, there may be regions where the crystal orientation cannot be measured due to factors, such as roughness, residual strain caused by polishing, contamination, the presence of an oxide film, and the like, of the measurement surface. Therefore, a confidence index was defined, and based on this confidence index, the orientation ratios were automatically calculated by the dedicated software, using as the population only the area where crystal orientations were successfully identified in the measurement region. In other words, the orientation ratios were determined by excluding portions where the crystal orientation could not be measured, as well as portions where the measured crystal orientations had low confidence indices. Here, when the dedicated software provides parameters for the confidence index, the confidence index can be set using such parameters. Specifically, several parameters such as a Confidential Index (CI value) and Image Quality (IQ value) can be used to select criteria for determining whether or not the reliability requirement is satisfied, according to the condition of the sample and the purpose of the analysis. For example, the CI value was set to 0.1 or more, and the portions where the CI value was less than 0.1 were excluded. In addition, the measurement results of portions where the measurement confidence index was low were complemented by replacing the orientation data of pixels where the measurement confidence index was low with the data of pixels where the measurement was normally performed around the pixels, using the cleanup processing included in the dedicated software. This method is effective for removing the scattered pixels where the measurement confidence index is low. However, since the noise of the projected image increases when the cleanup processing is excessive, for example, when 2 or more pixels are connected with an orientation difference of 10° or less, it was considered that 1 crystal grain was recognized. Then, the Grain Dilation method was performed once, and the Grain CI Standardization method was further performed once.

Table 2 below shows, in cross section perpendicular to the longitudinal direction, the <112> orientation ratios having an angular difference of 10° or less with respect to the longitudinal direction and the average crystal grain diameters of the respective aluminum wiring materials of Examples and Comparative Examples, which were obtained as described above.

(Measurement of aspect ratio and distribution of aspect ratio of precipitated particles)

The wire having the final wire diameter of 400 $\mu$m after the tempering heat treatment was sampled by the sampling method described above. The particle diameters of the precipitated particles were observed in a wide cross section perpendicular to the wire axis (lateral cross section) by FE-SEM (field emission scanning electron microscope, JSM-7800F manufactured by JEOL) at a magnification of 400 times, and 1 to 3 locations of the particle distribution, which were considered to be average, from the wide cross section were observed at a magnification of 1,000 times. The SEM imaging was performed by setting the conditions thereof with the acceleration voltage of 5 kV and a working distance (W.D.) of 10 mm, and selecting backscattered electron imaging (BED-C). In the image analysis, the brightness value of the captured SEM image was normalized to fall within the range of 0 to 1, and then binarized with a threshold value of 0.95. A region with a brightness value higher than the threshold value was defined as a precipitated particle.

In the image analysis, among regions on an image that were recognized as particles, pixels that were adjacent to each other in an 8-neighbor relationship were determined to constitute one particle. The term 8-neighbor refers to eight directions - up, down, left, right, and four diagonal directions rotated by 45° - with respect to a predetermined region recognized as a particle as a center, and a region that is in contact in the predetermined region in any of these eight directions is defined as one particle. Note that if only the predetermined region is recognized as a particle and no region is in contact with it in any of the eight directions, the region is not determined to be a particle.

Next, the aspect ratio (a ratio of the major axis to the minor axis when the shape of each precipitated particle is approximated by an ellipse circumscribing the precipitated particle (major axis/minor axis)) and the number of precipitated particles in the entire cross section perpendicular to the wire axis direction were measured. Then, the ratio of the number of precipitated particles having an aspect ratio of 4 or more to the total number of precipitated particles was expressed as a percentage. The ratio of the number of precipitated particles was almost the same at any of the leading end, trailing end and intermediate sections of the wire. The ratio of the number of precipitated particles in each Example is shown in Table 2. The ratio of the number of precipitated particles having an aspect ratio of 4 or more to the total number of precipitated particles in each of Example 3 and Comparative Example 9 is shown in Table 4.

(Measurement of load stress ratio)

The load stress ratio was determined by the following method. Each of the aluminum wiring materials of Examples and Comparative Examples was prepared to obtain an evaluation sample having a measurement length of 100 mm. Using this evaluation sample, a tensile fatigue test was performed at a room temperature of 15 to 28°C by a test machine dedicated to tensile fatigue test (Electro Plus E3000 manufactured by Illinois Tool Works, Inc.), thereby measuring the fatigue limit (MPa). Both ends of the evaluation sample were pulled so that loading at the maximum load stress and unloading at the minimum load stress were repeated at a speed of 5 Hz (5 cycles per second) with the maximum number of cycles exceeding $10^7$ cycles. The maximum load stress at three or more different load cycles were plotted on a semi-logarithmic graph of an S-N curve, and an approximate straight line was obtained from the plotted points by the least square method. Based on the approximate straight line, the fatigue limit (MPa) after $10^7$ cycles was determined.

Each of the aluminum wiring materials of Examples and Comparative Examples was cut to a length slightly longer than 100 mm to obtain evaluation samples separately. Tensile strength, that is, maximum load (Kgf), was measured by a tensile test at room temperature of 15 to 28°C. A maximum load in the tensile test can be measured by a tensile testing device. The maximum load is calculated as the maximum value until rupture when the evaluation sample of the aluminum wiring material with a measurement length of 100 mm is pulled continuously at a speed of 20 mm/min and a load cell rated load of 100 N by a tensile testing device (for example, Autograph, Model: AGS-5kNX manufactured by Shimadzu Corporation). The maximum load is a force applied to the wiring material pulled at the speed described above, and is usually automatically calculated by converting the tensile force into an electric signal by a load cell. The maximum load was calculated by taking into account the variation of the measurement results, and the average value of 3 evaluation samples was obtained. A tensile strength (MPa) was obtained by dividing the maximum load by the cross-sectional area of the wiring material.

The load stress ratio was calculated from the fatigue limit and tensile strength measured by the above-described methods using the following equation.

```
Load stress ratio = fatigue limit/tensile strength
```

The load stress ratio of each of the aluminum wiring materials of Example and Comparative Example obtained as described above is shown in Table 2 below.

(Measurement of proof stress ratio)

Each of the aluminum wiring materials of Examples and Comparative Examples was cut to a length slightly longer than 100 mm to obtain evaluation samples for measuring the proof stress ratio. The maximum load (Kgf) and the 0.2% strain load (Kgf) of each sample were determined by a tensile test under the same conditions as described above, and each divided by the cross-sectional area of each sample. Then, the proof stress ratio was calculated by the following equation:

Proof stress ratio = maximum stress/0.2% proof stress (stress)

The proof stress ratio of each of the aluminum wiring materials of Examples and Comparative Examples obtained as described above is shown in Table 2 below.

(Measurement of element concentration)

The concentrations of elements in each of the aluminum wiring materials of Examples and Comparative Examples were measured as follows. About 0.5 g of the manufactured wiring material was dissolved. The concentration of each element in the solution were determined by high-frequency inductively coupled plasma optical emission spectrometry (ICPE-9000 manufactured by Shimadzu Corporation). The elements other than aluminum measured here are iron (Fe), silicon (Si), gallium (Ga), vanadium (V), magnesium (Mg), copper (Cu), nickel (Ni), zinc (Zn), chromium (Cr), manganese (Mn), titanium (Ti), zirconium (Zr), tungsten (W), and scandium (Sc), and their contents are shown in Table 2 below. In the following table, the abbreviation "mass" means mass (quantity of matter).

Table 2 shows the chemical compositions of the aluminum wiring materials of Examples and Comparative Examples obtained above. Next, the aluminum wiring materials obtained above were subjected to the following performance evaluations.

(Power cycle test)

Each of the aluminum wiring materials of Examples and Comparative Examples was bonded on an aluminum alloy electrode of a power chip using ultrasonic bonding apparatus (Wire Bonder REBO7 manufactured by Ultrasonic Engineering Co., Ltd.). For each aluminum wiring material, the ultrasonic energy and the pressing force during bonding were each set so that the length in the longitudinal direction of the wiring material at the bonding portion was 500 $\mu$m. After bonding the aluminum wiring material, the power chip was subjected to a power cycle test by setting the current, energization time, and cooling time so that the maximum temperature (Tjmax) of the power chip was 150°C and the minimum temperature (Tjmin) was 25°C, i.e., so that the temperature difference ($\Delta$Tj) between the maximum temperature and the minimum temperature was 125°C. At this time, the energization time was about 7 seconds, the energization stop time was about 13 seconds, and 1 cycle was about 20 seconds.

The number of cycles when the energization was not possible was defined as the life in the power cycle test (power cycle life). A sample with a power cycle life of 60,000 cycles or more was judged as "S" (superior), since the life exceeded the target. A sample with a power cycle life of 40,000 cycles or more but less than 60,000 cycles was judged as "A" (good), since the life was at the target level. A sample with a power cycle life of 20,000 cycles or more but less than 40,000 cycles was judged as "B" (acceptable), since the life was considered passable. A sample with a power cycle life of less than 20,000 cycles was judged as "C" (unacceptable). Table 3 shows the evaluation of the power cycle test (thermal cycle) of each of the aluminum wiring materials in Examples and Comparative Examples.

(Vibration resistance)

Each of the aluminum wiring materials of Examples and Comparative Examples was bonded to two aluminum plates at each of the first bonding portion and the second bonding portion with an ultrasonic bonding apparatus (Wire Bonder REBO7 manufactured by Ultrasonic Engineering Co., Ltd.) so that the height and the length of a loop were 1 mm and 7 mm, respectively, to obtain an evaluation sample. The loop length refers to a direct distance between both ends of the first bonding and the second bonding. Using this evaluation sample, a vibration fatigue test was performed using a test machine dedicated to vibration fatigue manufactured on the basis of JIS standard (CV-101M manufactured by AS ONE Corporation), so that vibration resistance was evaluated. In the vibration fatigue test, vibration at a frequency of 50 Hz, an acceleration of 1 G, and an amplitude of 0.099 mm was applied to each evaluation sample until fracture. In the vibration fatigue test, an evaluation sample in which the total number of vibrations until fracture exceeded 50,000 was judged as "S," since it exceeded the target level. A sample in which the total number of vibrations until fracture was 10,000 or more and less than 50,000 was judged as "A," since it was at the target level. A sample in which the total number of vibrations until fracture was 5,000 or more and less than 10,000 was judged as "B," since it was considered passable. A sample in which the total number of vibrations until fracture was less than 5,000 was marked as "C," since it was considered unacceptable. Table 3 shows the evaluation of the vibration fatigue test of each of the aluminum wiring materials in Examples and Comparative Examples.

(Tool detachment evaluation)

Next, using an evaluation sample of an aluminum wiring material with a wire diameter of 400 $\mu$m, a first bonding and a second bonding were bonded to two aluminum plates using an ultrasonic bonding device (a wire bonder ASTERION manufactured by Kulicke & Soffa Industries, Inc.) so that the distance between them became 5 mm. The portion for the second bonding was bonded while the evaluation sample was bent at a target of 45° horizontally and laterally with respect to the axial direction of the wiring material. The bonding conditions were set such that the ultrasonic energy and the pressing force were optimized for the evaluation samples. The bonding tool used was manufactured by Kulicke & Soffa Industries, Inc. with model number: 127591-16, and the dimensions of an alligator clip for clipping the wiring material were 0.5 mm for the opening (inner diameter), 0.2 mm for the thickness (height), and 1.0 mm for the length (depth).

The determination of whether detachment failure from the tool occurred was made by observing the state of the wiring material at the second bonding portion.

Using the evaluation sample, bonding was performed 30 times (a combination of a first bonding and a second bonding is counted as one time). If the wiring material was not bonded, or if even one contact mark caused by one-sided contact with the tool was observed, as shown in the lower left of Fig. 1, the sample was judged as unacceptable and assigned a rating of "× (cross mark)". If the sample was normally bonded as shown in the lower right of Fig. 1, the sample was judged as acceptable and assigned a rating of "○ (circle mark)". These results are shown in Table 3.

Corrosion resistance tests under a high humidity environment were performed on the wiring materials of Example 1 and Comparative Example 11 as follows. The tests were performed for up to 1000 hours under conditions of 121°C and 100%RH (saturation) using a highly-accelerated life test apparatus. Wire cross-sections were prepared using a cross-section milling system and a corrosion layer was observed using FE-SEM to measure the thickness of the corrosion layer. As a result, it was confirmed that all the thicknesses of the corrosion layers were about 5 $\mu$m and that there was no problem in the use of the wiring materials.

(Comprehensive evaluation)

If all of the three aforementioned evaluations were rated as "S" and "○ (circle)," the sample was judged to be excellent, and the comprehensive evaluation was rated as "Superior." If all of the three aforementioned evaluations were rated "S," "A" or "○ (circle)," the sample was judged to be good, and the comprehensive evaluation was rated as "Good." If the three aforementioned evaluations were rated with the combination of other evaluations but did not include any of "C" or "× (cross)," the sample was judged to be passable, and the comprehensive evaluation was rated as "Acceptable." If even one of the three aforementioned evaluations was rated as "C" or "× (cross)," the sample was judged as unacceptable, and the comprehensive evaluation was rated as "Poor." These results are shown in Table 3.

(Power cycle and vibration fatigue test of resin-sealed chip)

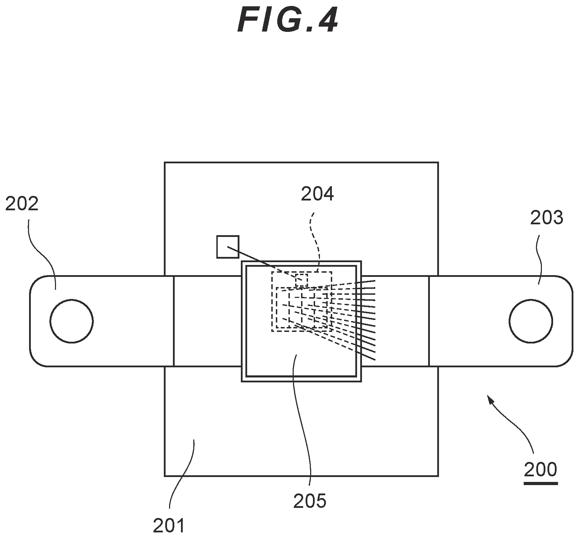

In order to evaluate the power cycle life and vibration fatigue in a resin-sealed state, a simulated power semiconductor device for evaluation was fabricated. Fig. 4 schematically shows a simulated power semiconductor device 200 for evaluation. As shown in Fig. 4, two stepped aluminum terminals 202 and 203 and an IGBT chip 204 were fixed to a tungsten carbide metal plate 201, having a length of 45 mm, a width of 40 mm and a thickness of 2 mm, by die-bonding. A metal spacer was disposed on the rear surface of one of the aluminum terminals 203 so as to be raised appropriately. Then, the IGBT chip 204 and the terminal 203 were bonded using each of the aluminum wiring materials of Examples and Comparative Examples, and a loop was formed so that the height of the surface of the terminal 203 from the top of the loop was 1 mm, the height of the top of the loop from the surface of the IGBT chip 204 was 10 mm, and so that the distance between both end faces of the wiring material bonding portion, that is, the length of the wiring material was 7 mm in the shortest case or 20 mm in the longest case. After that, a wall was formed around the IGBT chip with a commercially available resin dam agent, and the inside of the wall, including the IGBT chip and the bonding portions of the wiring material, was filled with a silicone gel sealing resin.

A power cycle test and a vibration fatigue test were performed as a thermal vibration fatigue test on the simulated power semiconductor device fabricated by the aforementioned method. That is, in order to reproduce a load close to a thermal stress and a stress caused by vibration in an actual device, 4,320 cycles of the power cycle test (20 seconds × 4320 times = 24 hours) and the subsequent vibration test of the semiconductor device itself (24 hours) were considered as 1 cycle in this test, and an energization test was performed every 1 cycle. The vibration test was performed under the conditions of the vibration fatigue test described above.

The number of cycles at which energization was not possible was defined as the life in the test. A sample having a life of 12 cycles or more was judged as "Superior," meaning that it had a life exceeding the target. A sample having a life of 8 cycles or more but less than 12 cycles was judged as "Good," meaning that it was at the target level. A sample having a life of 4 cycles or more but less than 8 cycles was judged as "Acceptable," meaning that it was passable. A sample having a life of less than 4 cycles was judged as "Poor," meaning that it was unacceptable. The evaluation of the thermal vibration fatigue test of each of the aluminum wiring materials in Examples and Comparative Examples is shown in Table 5. Comparative Examples 9, 10 and 11 were not evaluated because the tool detachment evaluation was unacceptable. The results are shown in Table 5. In Table 5, a part of the chemical composition of the wiring material was omitted.

(Evaluation of rolled wiring material)

Furthermore, a sample, which was prepared under the same processing conditions as those in Example 1 using aluminum having the chemical composition shown in Table 6, was rolled into a ribbon shape so that the length of the long side was 2 mm and the length of the short side was 0.2 mm. The resulting ribbon-shaped wiring material was used and loop-bonded between two aluminum plates as in Example 1. At this time, the ribbon-shaped wiring material was bonded and evaluated under the same conditions as those in Example 1, except that in the second bonding, the wiring material was bonded while bending at a target of 20° horizontally and laterally with respect to the axial direction of the wiring material. The results are shown in Table 6. An aluminum wiring material having the chemical composition shown in Table 7 was prepared as in Example 1, and the resulting sample was rolled into a ribbon shape so that the length of the long side was 2 mm and the length of the short side was 0.2 mm. The above-mentioned "thermal vibration fatigue test of resin-sealed chip" was performed using the obtained ribbon-shaped wiring material. The results are shown in Table 7.

[Table 2]

| | No. | CHEMICAL COMPOSITION | | | | | | | | | | | | | | |
|---|---|---|---|---|---|---|---|---|---|---|---|---|---|---|---|---|
| | | Al | Fe | Si | Ga | V | Mg | Cu | Ni | Zn | Cr | Mn | Ti | Zr | W | Sc |
| | | MASS % | | | MASS ppm | | | | | | | | | | | |
| EXAMPLES | 1 | 99.05 | 0.47 | 0.47 | 27 | 25 | 0 | 0 | 0 | 0 | 0 | 0 | 0 | 0 | 0 | 0 |
| | 2 | 99.05 | 0.47 | 0.47 | 27 | 25 | 0 | 0 | 0 | 0 | 0 | 0 | 0 | 0 | 0 | 0 |
| | 3 | 99.05 | 0.47 | 0.47 | 27 | 25 | 0 | 0 | 0 | 0 | 0 | 0 | 0 | 0 | 0 | 0 |
| | 4 | 99.05 | 0.47 | 0.47 | 27 | 25 | 0 | 0 | 0 | 0 | 0 | 0 | 0 | 0 | 0 | 0 |
| | 5 | 99.09 | 0.45 | 0.45 | 25 | 26 | 0 | 0 | 0 | 0 | 0 | 0 | 0 | 0 | 0 | 0 |
| | 6 | 99.09 | 0.45 | 0.45 | 25 | 26 | 0 | 0 | 0 | 0 | 0 | 0 | 0 | 0 | 0 | 0 |
| | 7 | 99.09 | 0.45 | 0.45 | 25 | 26 | 0 | 0 | 0 | 0 | 0 | 0 | 0 | 0 | 0 | 0 |
| | 8 | 99.09 | 0.45 | 0.45 | 25 | 26 | 0 | 0 | 0 | 0 | 0 | 0 | 0 | 0 | 0 | 0 |
| | 9 | 99.45 | 0.27 | 0.27 | 26 | 27 | 0 | 0 | 0 | 0 | 0 | 0 | 0 | 0 | 0 | 0 |
| | 10 | 99.45 | 0.27 | 0.27 | 26 | 27 | 0 | 0 | 0 | 0 | 0 | 0 | 0 | 0 | 0 | 0 |
| | 11 | 99.45 | 0.27 | 0.27 | 26 | 27 | 0 | 0 | 0 | 0 | 0 | 0 | 0 | 0 | 0 | 0 |
| | 12 | 99.45 | 0.27 | 0.27 | 26 | 27 | 0 | 0 | 0 | 0 | 0 | 0 | 0 | 0 | 0 | 0 |
| | 13 | 99.79 | 0.06 | 0.06 | 372 | 375 | 0 | 0 | 0 | 0 | 0 | 0 | 0 | 0 | 0 | 0 |
| | 14 | 99.79 | 0.06 | 0.06 | 372 | 375 | 0 | 0 | 0 | 0 | 0 | 0 | 0 | 0 | 0 | 0 |
| | 15 | 99.79 | 0.06 | 0.06 | 372 | 375 | 0 | 0 | 0 | 0 | 0 | 0 | 0 | 0 | 0 | 0 |
| | 16 | 99.79 | 0.06 | 0.06 | 372 | 375 | 0 | 0 | 0 | 0 | 0 | 0 | 0 | 0 | 0 | 0 |
| | 17 | 99.89 | 0.05 | 0.05 | 26 | 28 | 0 | 0 | 0 | 0 | 0 | 0 | 0 | 0 | 0 | 0 |
| | 18 | 99.89 | 0.05 | 0.05 | 26 | 28 | 0 | 0 | 0 | 0 | 0 | 0 | 0 | 0 | 0 | 0 |
| | 19 | 99.89 | 0.05 | 0.05 | 26 | 28 | 0 | 0 | 0 | 0 | 0 | 0 | 0 | 0 | 0 | 0 |
| | 20 | 99.89 | 0.05 | 0.05 | 26 | 28 | 0 | 0 | 0 | 0 | 0 | 0 | 0 | 0 | 0 | 0 |
| | 21 | 99 | 0.92 | 0 | 27 | 24 | 0 | 0 | 0 | 0 | 0 | 0 | 0 | 0 | 0 | 0 |
| | 22 | 99.5 | 0 | 0.43 | 25 | 28 | 0 | 0 | 0 | 0 | 0 | 0 | 0 | 0 | 0 | 0 |
| | 23 | 99.7 | 0.1 | 0.1 | 779 | 0 | 0 | 0 | 0 | 0 | 0 | 0 | 0 | 0 | 0 | 0 |
| | 24 | 99.7 | 0.1 | 0.1 | 0 | 763 | 0 | 0 | 0 | 0 | 0 | 0 | 0 | 0 | 0 | 0 |
| | 25 | 99.78 | 0.1 | 0.1 | 25 | 26 | 51 | 0 | 0 | 0 | 0 | 0 | 0 | 0 | 0 | 0 |
| | 26 | 99.78 | 0.1 | 0.1 | 24 | 26 | 0 | 52 | 0 | 0 | 0 | 0 | 0 | 0 | 0 | 0 |
| | 27 | 99.78 | 0.1 | 0.1 | 25 | 27 | 0 | 0 | 50 | 0 | 0 | 0 | 0 | 0 | 0 | 0 |
| | 28 | 99.78 | 0.1 | 0.1 | 24 | 26 | 0 | 0 | 0 | 51 | 0 | 0 | 0 | 0 | 0 | 0 |
| | 29 | 99.78 | 0.1 | 0.1 | 27 | 25 | 0 | 0 | 0 | 0 | 51 | 0 | 0 | 0 | 0 | 0 |
| | 30 | 99.78 | 0.1 | 0.1 | 25 | 26 | 0 | 0 | 0 | 0 | 0 | 54 | 0 | 0 | 0 | 0 |
| | 31 | 99.78 | 0.1 | 0.1 | 27 | 25 | 0 | 0 | 0 | 0 | 0 | 0 | 52 | 0 | 0 | 0 |
| | 32 | 99.78 | 0.1 | 0.1 | 27 | 25 | 0 | 0 | 0 | 0 | 0 | 0 | 0 | 51 | 0 | 0 |
| | 33 | 99.78 | 0.1 | 0.1 | 25 | 28 | 0 | 0 | 0 | 0 | 0 | 0 | 0 | 0 | 53 | 0 |
| | 34 | 99.78 | 0.1 | 0.1 | 24 | 27 | 0 | 0 | 0 | 0 | 0 | 0 | 0 | 0 | 0 | 51 |
| | 35 | 99.78 | 0.1 | 0.1 | 23 | 28 | 102 | 0 | 0 | 0 | 0 | 0 | 0 | 0 | 0 | 0 |
| | 36 | 99.78 | 0.1 | 0.1 | 27 | 24 | 0 | 100 | 0 | 0 | 0 | 0 | 0 | 0 | 0 | 0 |
| | 37 | 99.78 | 0.1 | 0.1 | 26 | 26 | 0 | 0 | 101 | 0 | 0 | 0 | 0 | 0 | 0 | 0 |
| | 38 | 99.78 | 0.1 | 0.1 | 27 | 24 | 0 | 0 | 0 | 103 | 0 | 0 | 0 | 0 | 0 | 0 |
| | 39 | 99.78 | 0.1 | 0.1 | 25 | 27 | 0 | 0 | 0 | 0 | 101 | 0 | 0 | 0 | 0 | 0 |
| | 40 | 99.78 | 0.1 | 0.1 | 24 | 27 | 0 | 0 | 0 | 0 | 0 | 101 | 0 | 0 | 0 | 0 |
| | 41 | 99.78 | 0.1 | 0.1 | 26 | 26 | 0 | 0 | 0 | 0 | 0 | 0 | 104 | 0 | 0 | 0 |
| | 42 | 99.78 | 0.1 | 0.1 | 25 | 26 | 0 | 0 | 0 | 0 | 0 | 0 | 0 | 101 | 0 | 0 |
| | 43 | 99.78 | 0.1 | 0.1 | 24 | 29 | 0 | 0 | 0 | 0 | 0 | 0 | 0 | 0 | 102 | 0 |
| | 44 | 99.78 | 0.1 | 0.1 | 25 | 27 | 0 | 0 | 0 | 0 | 0 | 0 | 0 | 0 | 0 | 103 |
| | 45 | 99.77 | 0.1 | 0.1 | 23 | 27 | 153 | 0 | 0 | 0 | 0 | 0 | 0 | 0 | 0 | 0 |
| | 46 | 99.77 | 0.1 | 0.1 | 23 | 27 | 0 | 152 | 0 | 0 | 0 | 0 | 0 | 0 | 0 | 0 |
| | 47 | 99.77 | 0.1 | 0.1 | 24 | 27 | 0 | 0 | 151 | 0 | 0 | 0 | 0 | 0 | 0 | 0 |
| | 48 | 99.77 | 0.1 | 0.1 | 25 | 26 | 0 | 0 | 0 | 154 | 0 | 0 | 0 | 0 | 0 | 0 |
| | 49 | 99.77 | 0.1 | 0.1 | 28 | 25 | 0 | 0 | 0 | 0 | 155 | 0 | 0 | 0 | 0 | 0 |
| | 50 | 99.77 | 0.1 | 0.1 | 26 | 25 | 0 | 0 | 0 | 0 | 0 | 151 | 0 | 0 | 0 | 0 |
| | 51 | 99.77 | 0.1 | 0.1 | 27 | 25 | 0 | 0 | 0 | 0 | 0 | 0 | 153 | 0 | 0 | 0 |
| | 52 | 99.77 | 0.1 | 0.1 | 27 | 24 | 0 | 0 | 0 | 0 | 0 | 0 | 0 | 151 | 0 | 0 |
| | 53 | 99.77 | 0.1 | 0.1 | 24 | 28 | 0 | 0 | 0 | 0 | 0 | 0 | 0 | 0 | 150 | 0 |
| | 54 | 99.77 | 0.1 | 0.1 | 23 | 27 | 0 | 0 | 0 | 0 | 0 | 0 | 0 | 0 | 0 | 151 |
| | 55 | 99.89 | 0.005 | 0.005 | 395 | 389 | 106 | 10 | 32 | 21 | 5 | 3 | 7 | 0 | 0 | 0 |
| COMPARATIVE EXAMPLES | 1 | 99.45 | 0.27 | 0.27 | 26 | 27 | 0 | 0 | 0 | 0 | 0 | 0 | 0 | 0 | 0 | 0 |
| | 2 | 99.79 | 0.06 | 0.06 | 372 | 375 | 0 | 0 | 0 | 0 | 0 | 0 | 0 | 0 | 0 | 0 |
| | 3 | 99.45 | 0.27 | 0.27 | 26 | 27 | 0 | 0 | 0 | 0 | 0 | 0 | 0 | 0 | 0 | 0 |
| | 4 | 99.79 | 0.06 | 0.06 | 372 | 375 | 0 | 0 | 0 | 0 | 0 | 0 | 0 | 0 | 0 | 0 |
| | 5 | 99.05 | 0.47 | 0.47 | 27 | 25 | 0 | 0 | 0 | 0 | 0 | 0 | 0 | 0 | 0 | 0 |
| | 6 | 99.79 | 0.1 | 0.1 | 0 | 0 | 0 | 0 | 0 | 0 | 0 | 0 | 0 | 0 | 0 | 0 |
| | 7 | 99.94 | 0.004 | 0.004 | 22 | 23 | 0 | 0 | 0 | 0 | 0 | 0 | 0 | 0 | 0 | 0 |
| | 8 | 99.97 | 0.01 | 0.01 | 0 | 0 | 0 | 0 | 0 | 0 | 0 | 0 | 0 | 0 | 0 | 0 |
| | 9 | 96.74 | 0.6 | 0.7 | 0 | 0 | 0 | 2021 | 0 | 1043 | 0 | 15011 | 0 | 0 | 0 | 0 |
| | 10 | 99.19 | 0.8 | 0 | 0 | 0 | 0 | 0 | 0 | 0 | 0 | 0 | 0 | 0 | 0 | 0 |
| | 11 | 99.99 | 0 | 0 | 0 | 0 | 0 | 0 | 0 | 0 | 0 | 0 | 0 | 0 | 0 | 0 |
| | 12 | 99.05 | 0.47 | 0.47 | 27 | 25 | 0 | 0 | 0 | 0 | 0 | 0 | 0 | 0 | 0 | 0 |
| | 13 | 98.97 | 0.47 | 0.47 | 432 | 427 | 0 | 0 | 0 | 0 | 0 | 0 | 0 | 0 | 0 | 0 |
| | 14 | 99.05 | 0.47 | 0.47 | 27 | 25 | 0 | 0 | 0 | 0 | 0 | 0 | 0 | 0 | 0 | 0 |
| | 15 | 99.05 | 0.47 | 0.47 | 27 | 25 | 0 | 0 | 0 | 0 | 0 | 0 | 0 | 0 | 0 | 0 |
| | 16 | 99.05 | 0.47 | 0.47 | 27 | 25 | 0 | 0 | 0 | 0 | 0 | 0 | 0 | 0 | 0 | 0 |
| | 17 | 99.05 | 0.47 | 0.47 | 27 | 25 | 0 | 0 | 0 | 0 | 0 | 0 | 0 | 0 | 0 | 0 |
| | 18 | 99.05 | 0.47 | 0.47 | 27 | 25 | 0 | 0 | 0 | 0 | 0 | 0 | 0 | 0 | 0 | 0 |
| | 19 | 99.05 | 0.47 | 0.47 | 27 | 25 | 0 | 0 | 0 | 0 | 0 | 0 | 0 | 0 | 0 | 0 |
| | 20 | 99.77 | 0.1 | 0.1 | 27 | 26 | 0 | 0 | 0 | 0 | 0 | 0 | 0 | 151 | 0 | 0 |
| | 21 | 99.88 | 0.004 | 0.005 | 26 | 25 | 0 | 0 | 0 | 0 | 0 | 0 | 0 | 0 | 0 | 0 |
| | 22 | 99.88 | 0.5 | 0.6 | 26 | 25 | 0 | 0 | 0 | 0 | 0 | 0 | 0 | 0 | 0 | 0 |
| | 23 | 99.05 | 0.47 | 0.47 | 25 | 23 | 0 | 0 | 0 | 0 | 0 | 0 | 0 | 0 | 0 | 0 |

[Table 3]

| | CHEMICAL COMPOSITION | | | | | | CHARACTERISTICS | | | | | | EVALUATION | | | COMPREHENSIVE EVALUATION |
|---|---|---|---|---|---|---|---|---|---|---|---|---|---|---|---|---|
| No. | Al | Fe | Si | Ga | V | Mg,Cu,Ni,Zn,Cr,Mn,Ti,Zr,W,Sc合計 | <112> | LOAD STRESS RATIO | PROOF STRESS RATIO | RATIO OF NUMBER OF PARTICLES HAVING AN ASPECT RATIO OF 4 OR MORE (×400) | RATIO OF NUMBER OF PARTICLES HAVING AN ASPECT RATIO OF 4 OR MORE (×1000) | AVERAGE CRYSTAL GRAIN DIAMETER | POWER CYCLE | VIBRATION FATIGUE | DETACHMENT FROM TOOL | |
| | MASS % | | | | MASS ppm | | PERCENTAGE % | - | - | PERCENTAGE % | PERCENTAGE % | μm | | | | |
| **EXAMPLES** | | | | | | | | | | | | | | | | |
| 1 | 99.05 | 0.47 | 0.47 | 27 | 25 | 0 | 8 | 0.43 | 1.96 | 1.91 | 7.24 | 22 | A | B | ○ | ACCEPTABLE |
| 2 | 99.05 | 0.47 | 0.47 | 27 | 25 | 0 | 22 | 0.54 | 1.93 | 3.51 | 9.91 | 36 | S | A | ○ | GOOD |
| 3 | 99.05 | 0.47 | 0.47 | 27 | 25 | 0 | 33 | 0.63 | 1.5 | 1.54 | 5.34 | 40 | S | A | ○ | GOOD |
| 4 | 99.05 | 0.47 | 0.47 | 27 | 25 | 0 | 41 | 0.7 | 1.91 | 2.84 | 7.65 | 38 | A | S | ○ | ACCEPTABLE |
| 5 | 99.09 | 0.45 | 0.45 | 25 | 26 | 0 | 10 | 0.45 | 1.46 | 4.73 | 15.93 | 45 | A | B | ○ | ACCEPTABLE |
| 6 | 99.09 | 0.45 | 0.45 | 25 | 26 | 0 | 24 | 0.59 | 1.9 | 1.48 | 4.03 | 32 | S | S | ○ | SUPERIOR |
| 7 | 99.09 | 0.45 | 0.45 | 25 | 26 | 0 | 31 | 0.6 | 1.45 | 3.27 | 12.49 | 23 | S | S | ○ | SUPERIOR |
| 8 | 99.09 | 0.45 | 0.45 | 25 | 26 | 0 | 39 | 0.74 | 1.59 | 1.34 | 4.06 | 17 | S | S | ○ | SUPERIOR |
| 9 | 99.45 | 0.27 | 0.27 | 26 | 27 | 0 | 11 | 0.48 | 1.11 | 3.25 | 11.72 | 24 | S | B | ○ | ACCEPTABLE |
| 10 | 99.45 | 0.27 | 0.27 | 26 | 27 | 0 | 25 | 0.52 | 1.39 | 4.32 | 15.8 | 43 | S | B | ○ | ACCEPTABLE |
| 11 | 99.45 | 0.27 | 0.27 | 26 | 27 | 0 | 32 | 0.64 | 1.47 | 2.62 | 7.12 | 37 | S | S | ○ | SUPERIOR |
| 12 | 99.45 | 0.27 | 0.27 | 26 | 27 | 0 | 43 | 0.73 | 1.21 | 1.99 | 5.37 | 42 | B | A | ○ | ACCEPTABLE |
| 13 | 99.79 | 0.06 | 0.06 | 372 | 375 | 0 | 9 | 0.45 | 1.12 | 3.32 | 12.77 | 22 | A | B | ○ | ACCEPTABLE |
| 14 | 99.79 | 0.06 | 0.06 | 372 | 375 | 0 | 21 | 0.55 | 2.03 | 4.32 | 15.55 | 34 | S | A | ○ | GOOD |
| 15 | 99.79 | 0.06 | 0.06 | 372 | 375 | 0 | 35 | 0.69 | 1.95 | 4.44 | 15.19 | 30 | S | A | ○ | GOOD |
| 16 | 99.79 | 0.06 | 0.06 | 372 | 375 | 0 | 42 | 0.85 | 1.15 | 2.97 | 10.36 | 30 | A | S | ○ | GOOD |
| 17 | 99.89 | 0.05 | 0.05 | 26 | 28 | 0 | 9 | 0.48 | 1.09 | 0.88 | 2.68 | 29 | A | B | ○ | ACCEPTABLE |
| 18 | 99.89 | 0.05 | 0.05 | 26 | 28 | 0 | 18 | 0.59 | 1.49 | 1.67 | 6.3 | 36 | S | S | ○ | SUPERIOR |
| 19 | 99.89 | 0.05 | 0.05 | 26 | 28 | 0 | 32 | 0.62 | 1.33 | 0.85 | 2.24 | 39 | S | A | ○ | GOOD |
| 20 | 99.89 | 0.05 | 0.05 | 26 | 28 | 0 | 43 | 0.73 | 1.25 | 2.01 | 6.24 | 19 | A | S | ○ | GOOD |
| 21 | 99 | 0.92 | 0 | 27 | 24 | 0 | 22 | 0.41 | 1.27 | 1.14 | 3.93 | 17 | S | B | ○ | ACCEPTABLE |
| 22 | 99.5 | 0 | 0.43 | 25 | 28 | 0 | 17 | 0.59 | 2.12 | 3.31 | 10.68 | 27 | S | A | ○ | GOOD |
| 23 | 99.7 | 0.1 | 0.1 | 779 | 0 | 0 | 11 | 0.69 | 1.31 | 0.83 | 2.13 | 37 | S | A | ○ | GOOD |
| 24 | 99.7 | 0.1 | 0.1 | 0 | 763 | 0 | 13 | 0.79 | 2 | 3.48 | 11.84 | 34 | S | S | ○ | GOOD |
| 25 | 99.78 | 0.1 | 0.1 | 25 | 26 | 51 | 7 | 0.41 | 1.08 | 1.67 | 5.42 | 29 | A | B | ○ | ACCEPTABLE |
| 26 | 99.78 | 0.1 | 0.1 | 24 | 26 | 52 | 19 | 0.55 | 1.6 | 1.21 | 3.86 | 21 | S | S | ○ | SUPERIOR |
| 27 | 99.78 | 0.1 | 0.1 | 25 | 27 | 50 | 31 | 0.65 | 1.64 | 1.14 | 3.35 | 17 | S | S | ○ | SUPERIOR |
| 28 | 99.78 | 0.1 | 0.1 | 24 | 26 | 51 | 42 | 0.71 | 1.78 | 3.78 | 13.06 | 29 | A | S | ○ | GOOD |
| 29 | 99.78 | 0.1 | 0.1 | 27 | 25 | 51 | 12 | 0.4 | 1.58 | 3.54 | 10.32 | 40 | S | B | ○ | ACCEPTABLE |
| 30 | 99.78 | 0.1 | 0.1 | 25 | 26 | 54 | 17 | 0.52 | 1.72 | 2.21 | 7.95 | 44 | S | A | ○ | GOOD |
| 31 | 99.78 | 0.1 | 0.1 | 27 | 25 | 52 | 28 | 0.62 | 1.93 | 1.65 | 5.4 | 15 | S | A | ○ | GOOD |
| 32 | 99.78 | 0.1 | 0.1 | 27 | 25 | 51 | 30 | 0.67 | 2.03 | 3.71 | 10.79 | 17 | S | A | ○ | GOOD |
| 33 | 99.78 | 0.1 | 0.1 | 25 | 28 | 53 | 38 | 0.74 | 1.46 | 0.78 | 2.91 | 44 | A | A | ○ | GOOD |
| 34 | 99.78 | 0.1 | 0.1 | 24 | 27 | 51 | 9 | 0.44 | 1.64 | 1.51 | 5.03 | 24 | S | A | ○ | GOOD |
| 35 | 99.78 | 0.1 | 0.1 | 23 | 28 | 102 | 18 | 0.55 | 1.07 | 1.1 | 3.58 | 14 | S | A | ○ | GOOD |
| 36 | 99.78 | 0.1 | 0.1 | 27 | 24 | 100 | 32 | 0.62 | 1.92 | 4.07 | 12.67 | 8 | S | A | ○ | GOOD |
| 37 | 99.78 | 0.1 | 0.1 | 26 | 26 | 101 | 40 | 0.72 | 1.35 | 2.23 | 7.84 | 34 | S | S | ○ | GOOD |
| 38 | 99.78 | 0.1 | 0.1 | 27 | 24 | 103 | 11 | 0.42 | 1.1 | 2.28 | 7.62 | 37 | S | B | ○ | GOOD |
| 39 | 99.78 | 0.1 | 0.1 | 25 | 27 | 101 | 22 | 0.57 | 1.68 | 1.6 | 4.21 | 24 | S | S | ○ | SUPERIOR |
| 40 | 99.78 | 0.1 | 0.1 | 24 | 27 | 101 | 33 | 0.63 | 1.61 | 2.83 | 9.66 | 27 | S | S | ○ | SUPERIOR |
| 41 | 99.78 | 0.1 | 0.1 | 26 | 26 | 104 | 43 | 0.81 | 1.4 | 3.19 | 12.43 | 18 | A | S | ○ | GOOD |
| 42 | 99.78 | 0.1 | 0.1 | 25 | 26 | 101 | 30 | 0.63 | 1.95 | 4.12 | 13.69 | 12 | S | A | ○ | GOOD |
| 43 | 99.78 | 0.1 | 0.1 | 24 | 29 | 102 | 7 | 0.47 | 1.13 | 2.58 | 6.63 | 20 | A | B | ○ | GOOD |
| 44 | 99.78 | 0.1 | 0.1 | 25 | 27 | 103 | 20 | 0.52 | 2.21 | 0.9 | 3.05 | 16 | S | A | ○ | GOOD |
| 45 | 99.77 | 0.1 | 0.1 | 23 | 27 | 153 | 31 | 0.65 | 1.56 | 3.47 | 9.49 | 32 | S | S | ○ | SUPERIOR |
| 46 | 99.77 | 0.1 | 0.1 | 23 | 27 | 152 | 38 | 0.78 | 1.92 | 2.19 | 7.25 | 35 | S | S | ○ | GOOD |
| 47 | 99.77 | 0.1 | 0.1 | 24 | 27 | 151 | 13 | 0.48 | 1.87 | 4.43 | 14.49 | 16 | S | A | ○ | GOOD |
| 48 | 99.77 | 0.1 | 0.1 | 25 | 26 | 154 | 23 | 0.53 | 1.59 | 1.98 | 5.75 | 31 | S | S | ○ | SUPERIOR |
| 49 | 99.77 | 0.1 | 0.1 | 28 | 25 | 155 | 30 | 0.63 | 1.05 | 4.96 | 15.71 | 37 | S | A | ○ | GOOD |
| 50 | 99.77 | 0.1 | 0.1 | 26 | 25 | 151 | 40 | 0.75 | 2.07 | 2.06 | 7.8 | 24 | S | S | ○ | SUPERIOR |
| 51 | 99.77 | 0.1 | 0.1 | 27 | 25 | 153 | 11 | 0.41 | 1.15 | 4.29 | 15.34 | 14 | S | B | ○ | GOOD |
| 52 | 99.77 | 0.1 | 0.1 | 27 | 24 | 151 | 12 | 0.48 | 1.82 | 4.51 | 12.26 | 12 | S | A | ○ | GOOD |
| 53 | 99.77 | 0.1 | 0.1 | 24 | 28 | 150 | 21 | 0.51 | 1.55 | 3.69 | 12.58 | 10 | S | S | ○ | SUPERIOR |
| 54 | 99.77 | 0.1 | 0.1 | 23 | 27 | 151 | 29 | 0.66 | 1.88 | 0.51 | 1.93 | 33 | S | S | ○ | SUPERIOR |
| 55 | 99.89 | 0.01 | 0.005 | 395 | 389 | 184 | 43 | 0.63 | 1.31 | 3.75 | 12.77 | 31 | A | A | ○ | ACCEPTABLE |
| **COMPARATIVE EXAMPLES** | | | | | | | | | | | | | | | | |
| 1 | 99.45 | 0.27 | 0.27 | 26 | 27 | 0 | 48 | 0.72 | 1.92 | 2.44 | 6.68 | 32 | C | S | ○ | POOR |
| 2 | 99.79 | 0.06 | 0.06 | 372 | 375 | 0 | 58 | 0.81 | 1.93 | 0.62 | 2.21 | 42 | C | A | ○ | POOR |
| 3 | 99.45 | 0.27 | 0.27 | 26 | 27 | 0 | 7 | 0.39 | 1.13 | 3.38 | 9.11 | 43 | B | C | ○ | POOR |
| 4 | 99.79 | 0.06 | 0.06 | 372 | 375 | 0 | 6 | 0.37 | 1.11 | 1.6 | 4.47 | 29 | S | C | ○ | POOR |
| 5 | 99.05 | 0.47 | 0.47 | 27 | 25 | 0 | 7 | 0.93 | 1.14 | 2.37 | 9 | 18 | A | C | ○ | POOR |
| 6 | 99.79 | 0.1 | 0.1 | 0 | 0 | 0 | 41 | 0.54 | 1.92 | 0.51 | 1.42 | 43 | B | B | ○ | POOR |
| 7 | 99.94 | 0 | 0.004 | 22 | 23 | 0 | 44 | 0.42 | 1.27 | 0.45 | 0.48 | 39 | C | B | × | POOR |
| 8 | 99.97 | 0.01 | 0.01 | 0 | 0 | 0 | 22 | 0.56 | 1.55 | 0.31 | 0.43 | 66 | S | A | × | POOR |
| 9 | 96.74 | 0.6 | 0.7 | 0 | 0 | 18075 | 25 | 0.69 | 1.6 | 0.1 | 0.33 | 5 | S | S | × | POOR |
| 10 | 99.19 | 0.8 | 0 | 0 | 0 | 0 | 18 | 0.6 | 1.65 | 5.01 | 16.21 | 10 | S | S | × | POOR |
| 11 | 99.99 | 0 | 0 | 0 | 0 | 0 | 21 | 0.53 | 1.4 | 0.01 | 0.03 | 82 | S | B | × | POOR |
| 12 | 99.05 | 0.47 | 0.47 | 27 | 25 | 0 | 20 | 0.39 | 2.32 | 2.23 | 6.95 | 18 | S | C | ○ | POOR |
| 13 | 98.97 | 0.47 | 0.47 | 432 | 427 | 0 | 12 | 0.91 | 1.91 | 3.62 | 9.71 | 24 | S | C | ○ | POOR |
| 14 | 99.05 | 0.47 | 0.47 | 27 | 25 | 0 | 46 | 0.42 | 1.41 | 3.71 | 10.9 | 31 | C | A | ○ | POOR |
| 15 | 99.05 | 0.47 | 0.47 | 27 | 25 | 0 | 2 | 0.91 | 1.89 | 4.47 | 15.66 | 33 | A | C | ○ | POOR |
| 16 | 99.05 | 0.47 | 0.47 | 27 | 25 | 0 | 14 | 0.39 | 1.46 | 3.45 | 11.67 | 7 | S | C | ○ | POOR |
| 17 | 99.05 | 0.47 | 0.47 | 27 | 25 | 0 | 17 | 0.44 | 2.31 | 1.41 | 5.2 | 28 | S | C | ○ | POOR |
| 18 | 99.05 | 0.47 | 0.47 | 27 | 25 | 0 | 18 | 0.58 | 1.84 | 0.28 | 0.48 | 14 | S | S | × | POOR |
| 19 | 99.05 | 0.47 | 0.47 | 27 | 25 | 0 | 21 | 0.61 | 1.54 | 5.03 | 16.32 | 28 | S | S | × | POOR |
| 20 | 99.77 | 0.1 | 0.1 | 27 | 26 | 151 | 11 | 0.52 | 2.01 | 0.26 | 0.47 | 14 | S | A | × | POOR |
| 21 | 99.88 | 0 | 0.005 | 26 | 25 | 0 | 46 | 0.72 | 1.57 | 3.27 | 9.28 | 42 | C | S | ○ | POOR |
| 22 | 99.88 | 0.5 | 0.6 | 26 | 25 | 0 | 5 | 0.92 | 1.92 | 1.71 | 5.62 | 16 | S | C | ○ | POOR |
| 23 | 99.05 | 0.47 | 0.47 | 25 | 23 | 0 | 47 | 0.81 | 1.62 | 2.58 | 8.38 | 41 | C | S | ○ | POOR |

[Table 4]

|  | TOTAL NUMBER OF PARTICLES | RATIO OF NUMBER OF PARTICLES HAVING AN ASPECT RATIO OF 4 OR MORE |
|---|---|---|
| EXAMPLES 3 | 297 PARTICLES | 5. 34% |
| COMPARATIVE EXAMPLES 9 | 2,754 PARTICLES | 0.33% |

[Table 5]

| | No. | Al | Fe | Si | Ga | V | Mg,Cu,Ni,Zn,Cr,Mn,Ti,Zr,W,Scの合計 | <112> | LOAD STRESS RATIO | PROOF STRESS RATIO | AVERAGE CRYSTAL GRAIN DIAMETER | THERMAL VIBRATION FATIGUE |
|---|---|---|---|---|---|---|---|---|---|---|---|---|
| | | MASS % | | | MASS ppm | | | PERCENTAGE % | - | - | μm | |
| EXAMPLES | 1 | 99.05 | 0.47 | 0.47 | 27 | 25 | 0 | 8 | 0.43 | 1.96 | 22 | ACCEPTABLE |
| | 2 | 99.05 | 0.47 | 0.47 | 27 | 25 | 0 | 22 | 0.54 | 1.93 | 36 | GOOD |
| | 3 | 99.05 | 0.47 | 0.47 | 27 | 25 | 0 | 33 | 0.63 | 1.5 | 40 | GOOD |
| | 4 | 99.05 | 0.47 | 0.47 | 27 | 25 | 0 | 41 | 0.7 | 1.91 | 38 | ACCEPTABLE |
| | 5 | 99.09 | 0.45 | 0.45 | 25 | 26 | 0 | 10 | 0.45 | 1.46 | 45 | ACCEPTABLE |
| | 6 | 99.09 | 0.45 | 0.45 | 25 | 26 | 0 | 24 | 0.59 | 1.9 | 32 | SUPERIOR |
| | 7 | 99.09 | 0.45 | 0.45 | 25 | 26 | 0 | 31 | 0.6 | 1.45 | 23 | SUPERIOR |
| | 8 | 99.09 | 0.45 | 0.45 | 25 | 26 | 0 | 39 | 0.74 | 1.59 | 17 | SUPERIOR |
| | 9 | 99.45 | 0.27 | 0.27 | 26 | 27 | 0 | 11 | 0.48 | 1.11 | 24 | ACCEPTABLE |
| | 10 | 99.45 | 0.27 | 0.27 | 26 | 27 | 0 | 25 | 0.52 | 1.39 | 43 | ACCEPTABLE |
| | 11 | 99.45 | 0.27 | 0.27 | 26 | 27 | 0 | 32 | 0.64 | 1.47 | 37 | SUPERIOR |
| | 12 | 99.45 | 0.27 | 0.27 | 26 | 27 | 0 | 43 | 0.73 | 1.21 | 42 | ACCEPTABLE |
| | 13 | 99.79 | 0.06 | 0.06 | 372 | 375 | 0 | 9 | 0.45 | 1.12 | 22 | ACCEPTABLE |
| | 14 | 99.79 | 0.06 | 0.06 | 372 | 375 | 0 | 21 | 0.55 | 2.03 | 34 | GOOD |
| | 15 | 99.79 | 0.06 | 0.06 | 372 | 375 | 0 | 35 | 0.69 | 1.95 | 30 | GOOD |
| | 16 | 99.79 | 0.06 | 0.06 | 372 | 375 | 0 | 42 | 0.85 | 1.15 | 30 | GOOD |
| | 17 | 99.89 | 0.05 | 0.05 | 26 | 28 | 0 | 9 | 0.48 | 1.09 | 29 | ACCEPTABLE |
| | 18 | 99.89 | 0.05 | 0.05 | 26 | 28 | 0 | 18 | 0.59 | 1.49 | 36 | SUPERIOR |
| | 19 | 99.89 | 0.05 | 0.05 | 26 | 28 | 0 | 32 | 0.62 | 1.33 | 39 | GOOD |
| | 20 | 99.89 | 0.05 | 0.05 | 26 | 28 | 0 | 43 | 0.73 | 1.25 | 19 | GOOD |
| | 21 | 99 | 0.92 | 0 | 27 | 24 | 0 | 22 | 0.41 | 1.27 | 17 | ACCEPTABLE |
| | 22 | 99.5 | 0 | 0.43 | 25 | 28 | 0 | 17 | 0.59 | 2.12 | 27 | GOOD |
| | 23 | 99.7 | 0.1 | 0.1 | 779 | 0 | 0 | 11 | 0.69 | 1.31 | 37 | GOOD |
| | 24 | 99.7 | 0.1 | 0.1 | 0 | 763 | 0 | 13 | 0.79 | 2 | 34 | GOOD |
| | 25 | 99.78 | 0.1 | 0.1 | 25 | 26 | 51 | 7 | 0.41 | 1.08 | 29 | ACCEPTABLE |
| | 26 | 99.78 | 0.1 | 0.1 | 24 | 26 | 52 | 19 | 0.55 | 1.6 | 21 | SUPERIOR |
| | 27 | 99.78 | 0.1 | 0.1 | 25 | 27 | 50 | 31 | 0.65 | 1.64 | 17 | SUPERIOR |
| | 28 | 99.78 | 0.1 | 0.1 | 24 | 26 | 51 | 42 | 0.71 | 1.78 | 29 | GOOD |
| | 29 | 99.78 | 0.1 | 0.1 | 27 | 25 | 51 | 12 | 0.4 | 1.58 | 40 | ACCEPTABLE |
| | 30 | 99.78 | 0.1 | 0.1 | 25 | 26 | 54 | 17 | 0.52 | 1.72 | 44 | GOOD |
| | 31 | 99.78 | 0.1 | 0.1 | 27 | 25 | 52 | 28 | 0.62 | 1.93 | 15 | GOOD |
| | 32 | 99.78 | 0.1 | 0.1 | 27 | 25 | 51 | 30 | 0.67 | 2.03 | 17 | GOOD |
| | 33 | 99.78 | 0.1 | 0.1 | 25 | 28 | 53 | 38 | 0.74 | 1.46 | 44 | GOOD |
| | 34 | 99.78 | 0.1 | 0.1 | 24 | 27 | 51 | 9 | 0.44 | 1.64 | 24 | GOOD |
| | 35 | 99.78 | 0.1 | 0.1 | 23 | 28 | 102 | 18 | 0.55 | 1.07 | 14 | GOOD |
| | 36 | 99.78 | 0.1 | 0.1 | 27 | 24 | 100 | 32 | 0.62 | 1.92 | 8 | GOOD |
| | 37 | 99.78 | 0.1 | 0.1 | 26 | 26 | 101 | 40 | 0.72 | 1.35 | 34 | GOOD |
| | 38 | 99.78 | 0.1 | 0.1 | 27 | 24 | 103 | 11 | 0.42 | 1.1 | 37 | ACCEPTABLE |
| | 39 | 99.78 | 0.1 | 0.1 | 25 | 27 | 101 | 22 | 0.57 | 1.68 | 24 | SUPERIOR |
| | 40 | 99.78 | 0.1 | 0.1 | 24 | 27 | 101 | 33 | 0.63 | 1.61 | 27 | SUPERIOR |
| | 41 | 99.78 | 0.1 | 0.1 | 26 | 26 | 104 | 43 | 0.81 | 1.4 | 18 | GOOD |
| | 42 | 99.78 | 0.1 | 0.1 | 25 | 26 | 101 | 30 | 0.63 | 1.95 | 12 | GOOD |
| | 43 | 99.78 | 0.1 | 0.1 | 24 | 29 | 102 | 7 | 0.47 | 1.13 | 20 | ACCEPTABLE |
| | 44 | 99.78 | 0.1 | 0.1 | 25 | 27 | 103 | 20 | 0.52 | 2.21 | 16 | GOOD |
| | 45 | 99.77 | 0.1 | 0.1 | 23 | 27 | 153 | 31 | 0.65 | 1.56 | 32 | SUPERIOR |
| | 46 | 99.77 | 0.1 | 0.1 | 23 | 27 | 152 | 38 | 0.78 | 1.92 | 35 | GOOD |
| | 47 | 99.77 | 0.1 | 0.1 | 24 | 27 | 151 | 13 | 0.48 | 1.87 | 16 | GOOD |
| | 48 | 99.77 | 0.1 | 0.1 | 25 | 26 | 154 | 23 | 0.53 | 1.59 | 31 | SUPERIOR |
| | 49 | 99.77 | 0.1 | 0.1 | 28 | 25 | 155 | 30 | 0.63 | 1.05 | 37 | GOOD |
| | 50 | 99.77 | 0.1 | 0.1 | 26 | 25 | 151 | 40 | 0.75 | 2.07 | 24 | SUPERIOR |
| | 51 | 99.77 | 0.1 | 0.1 | 27 | 25 | 153 | 11 | 0.41 | 1.15 | 14 | ACCEPTABLE |
| | 52 | 99.77 | 0.1 | 0.1 | 27 | 24 | 151 | 12 | 0.48 | 1.82 | 12 | GOOD |
| | 53 | 99.77 | 0.1 | 0.1 | 24 | 28 | 150 | 21 | 0.51 | 1.55 | 10 | SUPERIOR |
| | 54 | 99.77 | 0.1 | 0.1 | 23 | 27 | 151 | 29 | 0.66 | 1.88 | 33 | SUPERIOR |
| | 55 | 99.89 | 0.005 | 0.005 | 395 | 389 | 184 | 43 | 0.63 | 1.31 | 31 | ACCEPTABLE |
| COMPARATIVE EXAMPLES | 1 | 99.45 | 0.27 | 0.27 | 26 | 27 | 0 | 48 | 0.72 | 1.92 | 32 | POOR |
| | 2 | 99.79 | 0.06 | 0.06 | 372 | 375 | 0 | 58 | 0.81 | 1.93 | 42 | POOR |
| | 3 | 99.45 | 0.27 | 0.27 | 26 | 27 | 0 | 7 | 0.39 | 1.13 | 43 | POOR |
| | 4 | 99.79 | 0.06 | 0.06 | 372 | 375 | 0 | 6 | 0.37 | 1.11 | 29 | POOR |
| | 5 | 99.05 | 0.47 | 0.47 | 27 | 25 | 0 | 7 | 0.93 | 1.14 | 18 | POOR |
| | 6 | 99.79 | 0.1 | 0.1 | 0 | 0 | 0 | 41 | 0.54 | 1.92 | 43 | POOR |
| | 7 | 99.94 | 0.004 | 0.004 | 22 | 23 | 0 | 44 | 0.42 | 1.27 | 39 | POOR |
| | 8 | 99.97 | 0.01 | 0.01 | 0 | 0 | 0 | 22 | 0.56 | 1.55 | 66 | POOR |
| | 9 | 96.74 | 0.6 | 0.7 | 0 | 0 | 18075 | 25 | 0.69 | 1.6 | 5 | NOT EVALUATED |
| | 10 | 99.19 | 0.8 | 0 | 0 | 0 | 0 | 18 | 0.6 | 1.65 | 10 | NOT EVALUATED |
| | 11 | 99.99 | 0 | 0 | 0 | 0 | 0 | 21 | 0.53 | 1.3 | 82 | NOT EVALUATED |
| | 12 | 99.05 | 0.47 | 0.47 | 27 | 25 | 0 | 20 | 0.39 | 2.32 | 18 | POOR |
| | 13 | 98.97 | 0.47 | 0.47 | 432 | 427 | 0 | 12 | 0.91 | 1.91 | 24 | POOR |
| | 14 | 99.05 | 0.47 | 0.47 | 27 | 25 | 0 | 46 | 0.42 | 1.41 | 31 | POOR |
| | 15 | 99.05 | 0.47 | 0.47 | 27 | 25 | 0 | 7 | 0.77 | 1.94 | 43 | POOR |
| | 16 | 99.05 | 0.47 | 0.47 | 27 | 25 | 0 | 2 | 0.91 | 1.89 | 33 | POOR |
| | 17 | 99.05 | 0.47 | 0.47 | 27 | 25 | 0 | 14 | 0.39 | 1.46 | 7 | POOR |
| | 18 | 99.05 | 0.47 | 0.47 | 27 | 25 | 0 | 17 | 0.44 | 2.31 | 28 | POOR |
| | 19 | 99.05 | 0.47 | 0.47 | 27 | 25 | 0 | 18 | 0.58 | 1.84 | 14 | NOT EVALUATED |
| | 20 | 99.05 | 0.47 | 0.47 | 27 | 25 | 0 | 21 | 0.61 | 1.54 | 28 | NOT EVALUATED |
| | 21 | 99.77 | 0.1 | 0.1 | 27 | 26 | 151 | 11 | 0.52 | 2.01 | 14 | NOT EVALUATED |
| | 22 | 99.88 | 0.004 | 0.005 | 26 | 25 | 0 | 46 | 0.72 | 1.57 | 42 | POOR |
| | 23 | 99.88 | 0.5 | 0.6 | 26 | 25 | 0 | 5 | 0.92 | 1.92 | 16 | POOR |
| | 24 | 99.05 | 0.47 | 0.47 | 25 | 23 | 0 | 47 | 0.81 | 1.62 | 41 | POOR |

# EP 4 756 050 A1

[Table 6]

| | | CHEMICAL COMPOSITION | | | | | | | | | | | | | | | | | CHARACTERISTICS | | | | | | EVALUATION | | | COMPRE-HENSIVE EVALUATION |
|---|---|---|---|---|---|---|---|---|---|---|---|---|---|---|---|---|---|---|---|---|---|---|---|---|---|---|---|---|
| No. | | MASS % | | | MASS ppm | | | | | | | | | | | | | <112> | LOAD STRESS RATIO | PROOF STRESS RATIO | RATIO OF NUMBER OF PARTICLES HAVING AN ASPECT RATIO OF 4 OR MORE (× 400) | RATIO OF NUMBER OF PARTICLES HAVING AN ASPECT RATIO OF 4 OR MORE (× 1000) | AVERAGE CRYSTAL GRAIN DIAMETER | POWER CYCLE | VIBRATION FATIGUE | DETACHMENT FROM TOOL | |
| | | Al | Fe | Si | Ga | V | Mg | Cu | Ni | Zn | Cr | Mn | Ti | Zr | W | Sc | PERCENTAGE % | - | - | PERCENTAGE % | PERCENTAGE % | μm | | | | |
| EXAMPLES | 56 | 99.79 | 0.06 | 0.06 | 372 | 375 | 0 | 0 | 0 | 0 | 0 | 0 | 0 | 0 | 0 | 0 | 11 | 0.48 | 1.46 | 3.02 | 10.72 | 22 | A | A | ○ | GOOD |
| | 57 | 99.7 | 0.1 | 0.1 | 773 | 0 | 0 | 0 | 0 | 0 | 0 | 0 | 0 | 0 | 0 | 0 | 16 | 0.64 | 1.28 | 1.02 | 3.97 | 11 | S | A | ○ | GOOD |
| | 58 | 99.7 | 0.1 | 0.1 | 0 | 769 | 0 | 0 | 0 | 0 | 0 | 0 | 0 | 0 | 0 | 0 | 12 | 0.81 | 2.03 | 3.71 | 12.6 | 28 | A | S | ○ | GOOD |

26

[Table 7]

| | No. | CHEMICAL COMPOSITION | | | | | | | | | | | | | | | | | CHARACTERISTICS | | | | EVALUATION |
| | | Al | Fe | Si | Ga | V | Mg | Cu | Ni | Zn | Cr | Mn | Ti | Zr | W | Sc | <112> | LOAD STRESS RATIO | PROOF STRESS RATIO | AVERAGE CRYSTAL GRAIN DIAMETER | THERMAL VIBRATION FATIGUE |
| | | MASS % | | | MASS ppm | | | | | | | | | | | | PERCENTAGE % | | | μm | |
| EXAMPLES | 56 | 99.79 | 0.06 | 0.06 | 372 | 375 | 0 | 0 | 0 | 0 | 0 | 0 | 0 | 0 | 0 | 0 | 11 | 0.48 | 1.46 | 22 | GOOD |
| | 57 | 99.7 | 0.1 | 0.1 | 773 | 0 | 0 | 0 | 0 | 0 | 0 | 0 | 0 | 0 | 0 | 0 | 16 | 0.64 | 1.28 | 11 | GOOD |
| | 58 | 99.7 | 0.1 | 0.1 | 0 | 769 | 0 | 0 | 0 | 0 | 0 | 0 | 0 | 0 | 0 | 0 | 12 | 0.81 | 2.03 | 28 | GOOD |

27

As described above, the aluminum wiring materials of Examples were able to simultaneously realize an improvement in vibration resistance, an improvement in heat resistance, and an improvement in conformability.
The aluminum wiring materials for power semiconductors of Examples can greatly contribute to the development of the power electronics industry, the automobile industry, the electric railway industry, the electric power industry, and the like.

**Claims**

1. An aluminum wiring material (51) comprising aluminum having a purity of less than 99.9 mass %;
   wherein in a cross section perpendicular to a longitudinal direction of the aluminum wiring material (51):

   an orientation ratio of a crystal orientation <112> having an angular difference of 10° or less with respect to the longitudinal direction is 45% or less,
   a ratio of a number of precipitated particles having an aspect ratio of 4 or more to a total number of precipitated particles in the cross section is 0.5% or more and 16% or less,
   a load stress ratio defined by the following expression (1) is 0.4 or more and 0.9 or less:

   $$\text{load stress ratio = fatigue limit/tensile strength} \quad (1),$$

   (1),
   a proof stress ratio defined by the following expression (2) is greater than 1.0 and 2.3 or less:

   $$\text{proof stress ratio = maximum stress/0.2\% proof stress}$$

   $$(2), \text{ and}$$

   (2), and
   the aluminum wiring material (51) contains, relative to a total amount of the aluminum wiring material (51), at least one element of iron (Fe) and silicon (Si) in a total amount of 0.01 mass % or more and 1 mass % or less, and at least one element of gallium (Ga) and vanadium (V) in a total amount of 50 mass ppm or more and 800 mass ppm or less.

2. The aluminum wiring material (51) according to claim 1, wherein the aluminum wiring material (51) has an average crystal grain diameter of 40 $\mu$m or less in the cross section perpendicular to the longitudinal direction of the aluminum wiring material (51).

3. The aluminum wiring material (51) according to claim 1 or 2, wherein the aluminum wiring material (51) further contains one or more elements selected from magnesium (Mg), copper (Cu), nickel (Ni), zinc (Zn), chromium (Cr), manganese (Mn), titanium (Ti), zirconium (Zr), tungsten (W), and scandium (Sc).

4. The aluminum wiring material (51) according to claim 1 or 2, wherein the aluminum wiring material (51) has a wire diameter of 15 $\mu$m or more and 700 $\mu$m or less.

5. The aluminum wiring material (51) according to claim 1 or 2, wherein the cross section perpendicular to the longitudinal direction of the aluminum wiring material (51) has a circular, obround, elliptical or flat elliptical shape.

6. The aluminum wiring material (51) according to claim 1 or 2, wherein an aluminum content in the aluminum wiring material (51) is 99 mass % or more and less than 99.9 mass % relative to the total amount of the aluminum wiring material (51).

7. A method for manufacturing an aluminum wiring material (51), the method comprising:

   preparing an aluminum alloy that has a purity of less than 99.9 mass % and contains, relative to a total amount thereof, at least one element of iron (Fe) and silicon (Si) in a total amount of 0.01 mass % or more and 1 mass % or less, and at least one element of gallium (Ga) and vanadium (V) in a total amount of 50 mass ppm or more and 800 mass ppm or less; and

subjecting the aluminum alloy to wire drawing,

wherein in a cross section perpendicular to a longitudinal direction of the aluminum wiring material (51),

an orientation ratio of a crystal orientation <112> having an angular difference of 10° or less with respect to the longitudinal direction of the aluminum wiring material (51) is 45% or less,

a ratio of a number of precipitated particles having an aspect ratio of 4 or more to a total number of precipitated particles of the aluminum wiring material (51) is 0.5% or more and 16% or less,

a load stress ratio defined by the following expression (1) is 0.4 or more and 0.9 or less:

```
load stress ratio = fatigue limit/tensile strength  (1),
```

and

a proof stress ratio defined by the following expression (2) is greater than 1.0 and 2.3 or less:

```
proof stress ratio = maximum stress/0.2% proof stress (2).
```

8. A method for manufacturing an aluminum wiring material (51), the method comprising:

preparing an aluminum alloy that has a purity of less than 99.9 mass % and contains, relative to a total amount thereof, at least one element of iron (Fe) and silicon (Si) in a total amount of 0.01 mass % or more and 1 mass % or less, and at least one element of gallium (Ga) and vanadium (V) in a total amount of 50 mass ppm or more and 800 mass ppm or less; and

subjecting the aluminum alloy to wire drawing so that an area reduction ratio (working ratio) per die is 5% or more and 40% or less,

wherein in a cross section perpendicular to a longitudinal direction of the aluminum wiring material (51),

an orientation ratio of a crystal orientation <112> having an angular difference of 10° or less with respect to the longitudinal direction of the aluminum wiring material (51) is 45% or less,

a ratio of a number of precipitated particles having an aspect ratio of 4 or more to a total number of precipitated particles is 0.5% or more and 16% or less,

a load stress ratio defined by the following expression (1) is 0.4 or more and 0.9 or less:

```
load stress ratio = fatigue limit/tensile strength  (1),
```

and

a proof stress ratio defined by the following expression (2) is greater than 1.0 and 2.3 or less:

```
proof stress ratio = maximum stress/0.2% proof stress

(2).
```

# FIG.1

| | BONDING EXAMPLE 1 | BONDING EXAMPLE 2 |
|---|---|---|
| FIRST BONDING PORTION | | |
| SECOND BONDING PORTION | | |

# FIG.2

# FIG.3

(a)

(b)

(c)

(d)

(e)

(f)

(g)

# FIG.4

# FIG.5

## FIG.6

P

## FIG.7

P

# FIG.8

## INTERNATIONAL SEARCH REPORT

| International application No. |
|---|
| **PCT/JP2024/026568** |

| A. | CLASSIFICATION OF SUBJECT MATTER |
|---|---|

*C22C 21/00*(2006.01)i; *C22F 1/00*(2006.01)i; *C22F 1/04*(2006.01)i; *H01B 1/02*(2006.01)i; *H01B 5/02*(2006.01)i; *H01L 21/60*(2006.01)i

FI: C22C21/00 A; C22F1/04 D; C22F1/00 625; C22F1/00 604; C22F1/00 606; C22F1/00 630H; C22F1/00 661A; C22F1/00 630K; C22F1/00 630M; C22F1/00 650D; C22F1/00 630G; C22F1/00 630A; C22F1/00 630B; C22F1/00 681; C22F1/00 685Z; C22F1/00 691B; C22F1/00 691C; C22F1/00 692A; C22F1/00 692B; C22F1/00 682; C22F1/00 694A; C22F1/00 686A; C22F1/00 661C; H01L21/60 301F; H01B1/02 B; H01B5/02 Z

According to International Patent Classification (IPC) or to both national classification and IPC

| B. | FIELDS SEARCHED |
|---|---|

Minimum documentation searched (classification system followed by classification symbols)

C22C21/00-21/18; C22F1/00; C22F1/04-1/057; H01B1/02; H01B5/02; H01L21/60

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | WO 2022/163606 A1 (TANAKA ELECTRONICS IND CO., LTD.) 04 August 2022 (2022-08-04) claims, paragraph [0068], examples, tables 1-18 | 1-8 |
| Y | | 1-8 |
| X | WO 2022/030620 A1 (THE FURUKAWA ELECTRIC CO., LTD.) 10 February 2022 (2022-02-10) claims, examples, table 1 | 1-8 |
| Y | | 1-8 |
| Y | WO 2019/188452 A1 (THE FURUKAWA ELECTRIC CO., LTD.) 03 October 2019 (2019-10-03) paragraph [0042] | 1-8 |

☑ Further documents are listed in the continuation of Box C.　☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **24 September 2024** | **08 October 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

**INTERNATIONAL SEARCH REPORT**

| International application No. |
| --- |
| **PCT/JP2024/026568** |

**C.    DOCUMENTS CONSIDERED TO BE RELEVANT**

| Category* | Citation of document, with indication, where appropriate, of the relevant passages | Relevant to claim No. |
| --- | --- | --- |
| A | JP 1-255637 A (SKY ALUM CO., LTD.) 12 October 1989 (1989-10-12) entire text, all drawings | 1-8 |

Form PCT/ISA/210 (second sheet) (July 2022)

**INTERNATIONAL SEARCH REPORT**
Information on patent family members

International application No.

**PCT/JP2024/026568**

| Patent document cited in search report | | | Publication date (day/month/year) | Patent family member(s) | | | Publication date (day/month/year) |
|---|---|---|---|---|---|---|---|
| WO | 2022/163606 | A1 | 04 August 2022 | US claims, paragraph [0080], examples, tables 1-18 | 2024/0105667 | A1 | |
| | | | | CN | 116848623 | A | |
| | | | | KR | 10-2023-0116044 | A | |
| WO | 2022/030620 | A1 | 10 February 2022 | US claims, examples, table 1 | 2023/0343480 | A1 | |
| | | | | CN | 114402401 | A | |
| WO | 2019/188452 | A1 | 03 October 2019 | US paragraph [0067] | 2021/0010110 | A1 | |
| | | | | EP | 3778947 | A1 | |
| | | | | KR | 10-2020-0130237 | A | |
| JP | 1-255637 | A | 12 October 1989 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013258324 A
- JP 2014129578 A
- JP 2020184655 A
- JP 2020059886 A
- JP 2022163606 A